# EUROPEAN PATENT APPLICATION

(11) **EP 4 622 437 A1**
(43) Date of publication of application: **24.09.2025**
(21) Application number: 24810436.6
(22) Date of filing: 22.05.2024
(51) Int. Cl.: H10N 30/20

(54) **TRANSDUCER, TRANSDUCING APPARATUS AND TERMINAL**

(30) Priority: 23.05.2023 CN 202310591729
(71) Applicant: Huawei Technologies Co., Ltd., Shenzhen, Guangdong 518129 (CN)
(72) Inventor: CHEN, Xuying, Shenzhen, Guangdong 518129 (CN); JIANG, Tao, Shenzhen, Guangdong 518129 (CN); GAO, Wei, Shenzhen, Guangdong 518129 (CN); PANG, Yu, Shenzhen, Guangdong 518129 (CN); XU, Jinghui, Shenzhen, Guangdong 518129 (CN)
(74) Representative: Isarpatent
(86) International application number: PCT/CN2024/094799
(87) International publication number: WO 2024/240197

(57) **Abstract**

A transducer, a transduction apparatus, and a terminal are provided, and belong to the field of device technologies. The transducer includes a substrate layer, a first electrode layer, a piezoelectric layer, a second electrode layer, a first protective layer, and a second protective layer that are sequentially arranged. A sum of target parameters of the piezoelectric layer, the second electrode layer, the first protective layer, and the second protective layer is a positive integer multiple of **n,** and 0.1≤n≤0.4; and a target parameter of any film layer in the transducer is a ratio of a thickness of the any film layer to a wavelength of a sound wave at an operating frequency of the transducer when the sound wave is transmitted at the any film layer. This application can resolve a problem that a structure of the transducer has a single feasible implementation. This application is applied to the transducer.

## Description

This application claims priority to Chinese Patent Application No. 202310591729.X, filed on May 23, 2023, and entitled "TRANSDUCER AND TRANSDUCTION APPARATUS", which is incorporated herein by reference in its entirety.

### TECHNICAL FIELD

This application relates to the field of device technologies, and in particular, to a transducer, a transduction apparatus, and a terminal.

### BACKGROUND

A transducer is a device that can convert between electric energy and mechanical energy. The transducer can convert between electric energy and mechanical energy based on a piezoelectric effect.

In a related technology, the transducer includes a substrate layer, and a first electrode layer, a piezoelectric layer, a second electrode layer, and a protective layer that are sequentially formed at the substrate layer. When a voltage is loaded between the first electrode layer and the second electrode layer, the piezoelectric layer located between the first electrode layer and the second electrode layer receives an electrical signal, and the piezoelectric layer can vibrate under an action of the electrical signal, to emit a sound wave outwards. In addition, when the piezoelectric layer receives a sound wave from the outside, the piezoelectric layer can generate an electrical signal based on the sound wave. The electrical signal may be transmitted to the outside of the transducer through the first electrode layer and the second electrode layer.

However, a structure of the transducer in the related technology has a single feasible implementation.

### SUMMARY

This application provides a transducer, a transduction apparatus, and a terminal, to resolve a problem in a related technology that a structure of the transducer has a single feasible implementation. The technical solutions are as follows:

According to a first aspect, this application provides a transducer. The transducer includes a substrate layer, a first electrode layer, a piezoelectric layer, a second electrode layer, a first protective layer, and a second protective layer that are sequentially arranged. The substrate layer may be insulated or may not be insulated, and the substrate layer mainly plays a support role of an overall structure. The first protective layer may be insulated or may not be insulated, and materials of the first protective layer and the second protective layer are different. The second protective layer may be insulated or conductive. This is not limited in this application.

The transducer has two strong reflection boundaries located on two sides of the piezoelectric layer, and a part that is in the transducer and that is located between the two strong reflection boundaries is a working part of the transducer. The working part is configured to emit a sound wave at an operating frequency of the transducer, and is further configured to receive the sound wave at the operating frequency and convert the sound wave into an electrical signal. An acoustic impedance difference between mediums on two adjacent sides of the strong reflection boundary is large. For example, an acoustic impedance of a medium adjacent to a side of a strong reflection boundary close to the piezoelectric layer is greater than twice an acoustic impedance of a medium adjacent to a side of the strong reflection boundary away from the piezoelectric layer, or is less than one half of an acoustic impedance of a medium adjacent to a side of the strong reflection boundary away from the piezoelectric layer.

Positions of the two strong reflection boundaries are not limited in this application, and correspondingly, composition of the working part is not limited. The working part of the transducer is configured to emit a sound wave at the operating frequency of the transducer based on an electrical signal, and generate a corresponding electrical signal based on a received sound wave at the operating frequency. A thickness of the working part is related to the operating frequency.

For example, the transducer includes a film layer group, and the film layer group includes two film layers located on the two sides of the piezoelectric layer. For any one of the two film layers, a difference between an acoustic impedance of the any film layer and an acoustic impedance of a medium (which may belong to the transducer or may not belong to the transducer) adjacent to a side of the any film layer away from the piezoelectric layer is large. For example, the acoustic impedance of the any film layer is greater than twice the acoustic impedance of the medium (which may belong to the transducer or may not belong to the transducer, or may be gas (such as air) or may not be gas but a physical structure) adjacent to the side of the any film layer away from the piezoelectric layer; or the acoustic impedance of the any film layer is less than one half of the acoustic impedance of the medium adjacent to the side of the any film layer away from the piezoelectric layer. In this way, surfaces of sides of two film layers in each film layer group away from the piezoelectric layer are strong reflection boundaries, and the two film layers and a film layer therebetween can form one working part. Herein, for example, the film layer group includes the two film layers. It may be understood that the film layer group may also include a film layer between the two film layers. In this case, the film layer group forms one working part.

It may be understood that, one of the two film layers included in the film layer group may also be a piezoelectric layer, and the other film layer may be located on any side of the piezoelectric layer. An acoustic impedance of the piezoelectric layer and an acoustic impedance of a medium (which may belong to the transducer or may not belong to the transducer) adjacent to a side of the piezoelectric layer away from the other film layer is large. An acoustic impedance of the other film layer and an acoustic impedance of a medium (which may belong to the transducer or may not belong to the transducer) adjacent to a side of the other film layer away from the piezoelectric layer is large. For example, the acoustic impedance of the piezoelectric layer is greater than twice the acoustic impedance of the medium adjacent to the side of the piezoelectric layer away from the other film layer, or the acoustic impedance of the piezoelectric layer is less than one half of the acoustic impedance of the medium adjacent to the side of the piezoelectric layer away from the other film layer. The acoustic impedance of the other film layer is greater than twice the acoustic impedance of the medium adjacent to the side of the other film layer away from the piezoelectric layer; or the acoustic impedance of the other film layer is less than one half of the acoustic impedance of the medium adjacent to the side of the other film layer away from the piezoelectric layer.

A sum of target parameters of two film layers in each film layer group and a film layer between the two film layers is a positive integer multiple of n, where 0.1≤n≤0.4, and n=0.25 or 0.25±0.15. Because an acoustic impedance of each film layer in the working part of the transducer is different, internal reflection of a sound wave still exists in the working part. Therefore, in some cases, when a sum of target parameters of film layers in the working part deviates from an integer multiple of 0.25 (for example, 0.25±0.15), the working part can still emit a sound wave at the operating frequency.

For example, when the transducer includes the substrate layer, the first electrode layer, the piezoelectric layer, the second electrode layer, the first protective layer, and the second protective layer that are sequentially arranged, a sum of target parameters of the piezoelectric layer, the second electrode layer, the first protective layer, and the second protective layer is a positive integer multiple of n. In this case, the two film layers in the film layer group are the piezoelectric layer and the second protective layer. A side of the piezoelectric layer away from the second protective layer is a strong reflection boundary, and a side of the second protective layer away from the piezoelectric layer is the other strong reflection boundary.

Compared with a transducer in the related technology, in the transducer provided in this application, there are two protective layers on a side of the second electrode layer away from the piezoelectric layer, and materials of the two protective layers are different. In this way, feasible implementations of the structure of the transducer are enriched.

A target parameter of any film layer in the transducer is a ratio of a thickness of the film layer to a wavelength of a sound wave at the operating frequency of the transducer when the sound wave is transmitted at the film layer. The wavelength of the sound wave at the operating frequency of the transducer when the sound wave is transmitted at the film layer is a ratio of a sound velocity of the sound wave at the operating frequency of the transducer when the sound wave is transmitted at the film layer to a frequency of the sound wave. Herein, the sound velocity of the sound wave at the operating frequency of the transducer when the sound wave is transmitted at the film layer may be a longitudinal wave sound velocity, a transverse wave sound velocity, or a guided-wave sound velocity. Therefore, the wavelength of the sound wave at the operating frequency of the transducer when the sound wave is transmitted at the film layer is: a ratio of a longitudinal wave sound velocity of the sound wave at the operating frequency of the transducer when the sound wave is transmitted at the film layer to the frequency of the sound wave at the operating frequency of the transducer; or a ratio of a transverse wave sound velocity of the sound wave at the operating frequency of the transducer when the sound wave is transmitted at the film layer to the frequency of the sound wave at the operating frequency of the transducer; or a ratio of a guided-wave sound velocity of the sound wave at the operating frequency of the transducer when the sound wave is transmitted at the film layer to the frequency of the sound wave at the operating frequency of the transducer.

Materials of the first protective layer and the second protective layer are not limited in embodiments of this application, provided that materials of the first protective layer and the second protective layer are different. In an optional implementation, a material of one of the first protective layer and the second protective layer includes adhesive, that is, this protective layer is an adhesive layer.

Optionally, when a material of one of the first protective layer and the second protective layer includes adhesive, acoustic damping of the other of the first protective layer and the second protective layer is less than acoustic damping of this protective layer, and/or roughness of a surface of a side of the other protective layer away from the piezoelectric layer is less than roughness of a surface of a side of this protective layer away from the piezoelectric layer. For example, a material of the other protective layer includes metal, and the material of the other protective layer may alternatively be non-metal. This is not limited in this application.

When one of the first protective layer and the second protective layer is an adhesive layer, and acoustic damping of the other protective layer is less than acoustic damping of this protective layer (the adhesive layer), overall acoustic damping of the first protective layer and the second protective layer is less than overall acoustic damping of the first protective layer and the second protective layer when both the first protective layer and the second protective layer are adhesive layers. In addition, when the overall acoustic damping of the first protective layer and the second protective layer is small, and the first protective layer and the second protective layer belong to the working part of the transducer, an overall loss of the sound wave at the first protective layer and the second protective layer is small, so that sensitivity of the transducer can be improved.

In addition, a rougher surface on which the strong reflection boundary is located indicates greater noise of the transducer. When roughness of a surface of a side of the second protective layer away from the piezoelectric layer is less than roughness of a surface of a side of the first protective layer away from the piezoelectric layer, and the first protective layer is an adhesive layer, if the surface of the side of the second protective layer away from the piezoelectric layer is a strong reflection boundary, noise of the transducer can be small.

The first electrode layer may include a plurality of first electrode blocks arranged in an array, the second electrode layer includes a second electrode block, an orthographic projection of the second electrode block at the substrate layer and an orthographic projection of the piezoelectric layer at the substrate layer have an overlapping region, and all orthographic projections of the plurality of first electrode blocks at the substrate layer are located in the overlapping region. It can be learned that the first electrode layer may be a pixelated electrode layer, and the first electrode block at the first electrode layer may be referred to as a pixel electrode. A region in which each first electrode block in the transducer is located is one transduction region, and a plurality of transduction regions in the transducer can perform transduction independently of each other. It may be understood that alternatively the first electrode layer may not be a pixelated electrode layer. For example, the first electrode layer includes only one first electrode block, and the transducer includes one transduction region in which the first electrode block is located. This is not limited in this application.

The transducer provided in this application includes a plurality of film layers, such as the substrate layer, the first electrode layer, the piezoelectric layer, the second electrode layer, the first protective layer, and the second protective layer. On a basis of implementing a basic function (transduction) of the transducer, there may be at least one first film layer in these film layers. An acoustic impedance of the piezoelectric layer differs greatly from an acoustic impedance of the first film layer in the transducer. For example, the acoustic impedance of the piezoelectric layer is greater than twice the acoustic impedance of the first film layer in the transducer, or the acoustic impedance of the piezoelectric layer is less than one half of the acoustic impedance of the first film layer. In addition, a target parameter of the first film layer is less than one tenth. In this application, an example in which at least one of the first electrode layer, the second electrode layer, the first protective layer, and the second protective layer is a first film layer is used.

For example, when the second electrode layer is a first film layer, the acoustic impedance of the piezoelectric layer is greater than twice an acoustic impedance of the second electrode layer, or the acoustic impedance of the piezoelectric layer is less than one half of the acoustic impedance of the second electrode layer; and the target parameter of the second electrode layer is less than one tenth. For another example, when the second protective layer is a first film layer, the acoustic impedance of the piezoelectric layer is greater than twice an acoustic impedance of the second protective layer, or the acoustic impedance of the piezoelectric layer is less than one half of the acoustic impedance of the second protective layer; and the target parameter of the second protective layer is less than one tenth. For still another example, when both the second electrode layer and the second protective layer are first film layers, the acoustic impedance of the piezoelectric layer is greater than twice the acoustic impedance of the second electrode layer, or the acoustic impedance of the piezoelectric layer is less than one half of the acoustic impedance of the second electrode layer; or the acoustic impedance of the piezoelectric layer is greater than twice the acoustic impedance of the second protective layer, or the acoustic impedance of the piezoelectric layer is less than one half of the acoustic impedance of the second protective layer; and the target parameter of the second electrode layer is less than one tenth, and the target parameter of the second protective layer is less than one tenth.

It can be learned that a difference between the acoustic impedance of the first film layer and the acoustic impedance of the piezoelectric layer is large. In this case, in this application, a thickness of the first film layer is reduced, so that the target parameter of the first film layer is less than one tenth, and the first film layer is used as an acoustically transparent layer. In this way, when the first film layer belongs to the working part of the transducer, a material of a film layer other than the first film layer and the piezoelectric layer in the working part may be set as a material with a small acoustic impedance difference from the piezoelectric layer, so that acoustic impedances of film layers in the working part are similar, reflection of a sound wave in the working part is reduced, and sensitivity of the transducer is improved.

When the first electrode layer or the second electrode layer is a first film layer, a thickness of the first electrode layer or the second electrode layer is thin, and process difficulties and costs of producing the first electrode layer or the second electrode layer may be low.

In the foregoing content, for example, the transducer includes the substrate layer, the first electrode layer, the piezoelectric layer, the second electrode layer, the first protective layer, and the second protective layer that are sequentially arranged. Optionally, the transducer may further include another film layer.

In an optional implementation, the transducer further includes a first additional layer, and the first additional layer is located on a side of the substrate layer away from the piezoelectric layer. Alternatively, the first additional layer may be located on the side of the second protective layer away from the piezoelectric layer. A material of the first additional layer is not limited in this application. For example, the material of the first additional layer is adhesive, and the first additional layer is also an adhesive layer.

In another optional implementation, the transducer further includes a second additional layer, a third additional layer, and a fourth additional layer, where the second additional layer is located on the side of the substrate layer away from the piezoelectric layer. The second additional layer, the third additional layer, and the fourth additional layer are sequentially arranged on the side of the substrate layer away from the piezoelectric layer in a direction away from the substrate layer. For example, both the second additional layer and the fourth additional layer include adhesive, the third additional layer includes copper, both the second additional layer and the fourth additional layer may be adhesive layers, and the third additional layer may be a copper layer. In this way, an entirety including the second additional layer, the third additional layer, and the fourth additional layer may be a copper adhesive tape.

Optionally, the transducer further includes a damping layer. The damping layer is a film layer located on an outer side of the transducer, and acoustic damping of the damping layer is greater than acoustic damping of an adjacent film layer of the damping layer in the transducer. When the transducer includes a damping layer, under an effect that acoustic damping of the damping layer is greater than acoustic damping of an adjacent film layer, sound energy output by the transducer can be attenuated quickly, and an oscillation attenuation time of the transducer is reduced. Because the oscillation attenuation time of the transducer is negatively correlated with a bandwidth, a bandwidth of the transducer can be increased. It can be learned that, disposing the damping layer in the transducer can increase a bandwidth of a sound wave emitted by the transducer.

Optionally, the transducer further includes a circuit layer located between the substrate layer and the first electrode layer, and the circuit layer is connected to the first electrode layer. The circuit layer is configured to process (preprocess) an electrical signal generated by the piezoelectric layer based on a received sound wave, and then output a processed electrical signal to the outside of the transducer.

Optionally, the transducer further includes an auxiliary adhesion layer located between the first electrode layer and the piezoelectric layer. A bonding force between the auxiliary adhesion layer and the first electrode layer and a bonding force between the auxiliary adhesion layer and the piezoelectric layer are both greater than a bonding force between the first electrode layer and the piezoelectric layer. In this way, compared with direct contact between the first electrode layer and the piezoelectric layer, when the auxiliary adhesion layer is disposed between the first electrode layer and the piezoelectric layer, a bonding effect between the first electrode layer and the piezoelectric layer is better.

The transducer may further include another film layer in addition to the foregoing film layers. Details are not described herein in this application. In addition, the transducer may alternatively not include the at least one optional film layer.

Further, in the foregoing content, for example, the transducer includes one film layer group. In this application, the transducer may alternatively include a plurality of film layer groups, and at least one film layer in different film layer groups is different. Two film layers in each film layer group and a part therebetween form one working part corresponding to the film layer group. A plurality of film layer groups can form a plurality of corresponding working parts. The plurality of working parts are each configured to emit a sound wave at the operating frequency of the transducer. In this way, sensitivity of the transducer can be improved. It can be learned that the transducer includes at least one film layer group, and two film layers in the film layer group are not limited in this application.

For example, the transducer includes two film layer groups. Two film layers in one film layer group (two film layers at edges of the film layer group) are a piezoelectric layer and a second protective layer, and two film layers in the other film layer group (two film layers at edges of the film layer group) are a substrate layer and a second protective layer. In this case, a sum of target parameters of the piezoelectric layer, the second electrode layer, the first protective layer, and the second protective layer is a positive integer multiple of n, and a sum of target parameters of the substrate layer, the first electrode layer, the piezoelectric layer, the second electrode layer, the first protective layer, and the second protective layer is a positive integer multiple of n.

For another example, the transducer includes two film layer groups. Two film layers in one film layer group (two film layers at edges of the film layer group) are a piezoelectric layer and a second protective layer, and two film layers in the other film layer group (two film layers at edges of the film layer group) are a third additional layer and a second protective layer. In this case, a sum of target parameters of the piezoelectric layer, the second electrode layer, the first protective layer, and the second protective layer is a positive integer multiple of n, and a sum of target parameters of the third additional layer, the second additional layer, the substrate layer, the first electrode layer, the piezoelectric layer, the second electrode layer, the first protective layer, and the second protective layer is a positive integer multiple of n.

For another example, the at least one film layer group includes at least one film layer of the piezoelectric layer and the second protective layer. For example, the two film layers in the film layer group include at least one film layer of the piezoelectric layer and the second protective layer. When the two film layers in the film layer group include the piezoelectric layer and the second protective layer, the piezoelectric layer, the second protective layer, and a film layer between the piezoelectric layer and the second protective layer form one working part, and a sum of target parameters of the film layers in the working part is an integer multiple of 0.25 (or 0.25±0.15).

For another example, the at least one film layer group includes at least one film layer of the substrate layer and the second protective layer. For example, the two film layers in the film layer group include at least one film layer of the substrate layer and the second protective layer. When the two film layers in the film layer group include the substrate layer and the second protective layer, the substrate layer, the second protective layer, and a film layer between the substrate layer and the second protective layer form one working part, and a sum of target parameters of film layers in the working part is an integer multiple of 0.25 (or 0.25±0.15).

For still another example, when the transducer includes the second additional layer, the third additional layer, and the fourth additional layer, the at least one film layer group includes the second additional layer or the third additional layer. For example, the film layer group includes the second additional layer or the third additional layer. When the two film layers in the film layer group include the second additional layer and the second protective layer, the second additional layer, the second protective layer, and a film layer between the second additional layer and the second protective layer form one working part, and a sum of target parameters of film layers in the working part is an integer multiple of 0.25 (or 0.25±0.15). When the two film layers in the film layer group include the third additional layer and the second protective layer, the third additional layer, the second protective layer, and a film layer between the third additional layer and the second protective layer form one working part, and a sum of target parameters of film layers in the working part is an integer multiple of 0.25 (or 0.25±0.15).

A plurality of features of the transducer are listed in the foregoing content. It may be understood that, on a basis that a transduction function of the transducer can be implemented, these features may be randomly combined as required. It can be learned that the transducer provided in this application may have at least one of the foregoing plurality of features.

One film layer in this application may be a one-layer structure, or may be obtained by superposing a plurality of layers of structures. Materials of different layers of structures in the plurality of layers of structures may be the same or may be different. One film layer herein may be any film layer in the resonator, for example, the second electrode layer, the first protective layer, or the second protective layer. Each of the at least one film layer in the transducer provided in this application may be obtained by superposing a plurality of layers of structures. This is not limited in this application. For example, the at least one film layer includes the second electrode layer, the first protective layer, and/or the second protective layer.

For example, when the second electrode layer is obtained by superposing a plurality of structures, the second electrode layer may be obtained by superposing a silver paste electrode layer and a sub-micrometer-thick metal layer. The sub-micrometer-thick metal layer may be sputtered on a surface of the silver paste electrode layer close to the piezoelectric layer, to improve surface roughness of the silver paste electrode layer. A material of the sub-micrometer-thick metal layer may be metal such as gold, copper, chromium, nickel, or aluminum.

For another example, when the first protective layer is obtained by superposing a plurality of layers of structures, the first protective layer includes two first polymer layers and a second polymer layer superposed between the two first polymer layers, and hardness of the second polymer layer is greater than hardness of the first polymer layer. The second polymer layer may function to electrically isolate the second electrode layer from the second protective layer. In addition, when a thickness of the first protective layer is fixed, compared with a first protective layer formed by one first polymer layer, a thickness of a first polymer layer in a first protective layer including two first polymer layers and one second polymer layer is reduced, so that a bubble size in the first polymer layer can be reduced. The first polymer layer may be a pressure sensitive adhesive (pressure sensitive adhesive, PSA), an optically clear adhesive (optically clear adhesive, OCA), a hot glue (hot glue), or the like. The rigid polymer layer may be a polyethylene terephthalate (polyethylene terephthalate, PET) layer, polyimide (polyimide, PI), polyethylene (polyethylene, PE), polypropylene (polypropylene, PP), polyvinyl chloride (polyvinyl chloride, PVC), polystyrene (polystyrene, PS), polycarbonate (polycarbonate, PC), or the like. When the first protective layer is of a one-layer structure, the first protective layer may be a PSA, OCA, or hot glue layer.

For still another example, when the second protective layer is obtained by superposing a plurality of layers of structures, the second protective layer may be obtained by superposing a copper layer and a film layer deposited on a side of the copper layer away from the piezoelectric layer. The film layer deposited on the side of the copper layer away from the piezoelectric layer may be an antioxidant metal layer (for example, metal such as aluminum, gold, or nickel) or a polymer protective layer. The film layer deposited on the side of the copper layer away from the piezoelectric layer can protect the copper layer, to prevent the copper layer from being oxidized.

Optionally, a material of the substrate is glass, silicon, or a polymer material.

Optionally, a material of the piezoelectric layer is an organic polymer material or an inorganic piezoelectric material.

Optionally, the operating frequency of the transducer ranges from 5 megahertz to 25 megahertz.

A thickness of each film layer in the transducer provided in this application may be set as required. For example, the thickness of each film layer in the transducer may be set based on the operating frequency (also referred to as a resonant frequency) of the transducer. For example, a thickness of the substrate layer may be 50 micrometers (µm), 70 µm, 90 µm, 120 µm, 150 µm, 200 µm, 250 µm, 300 µm, or the like; a thickness of the piezoelectric layer may be 5 µm, 7 µm, 9 µm, 11 µm, 15 µm, 20 µm, or the like; a thickness of the second electrode layer may be 2 µm, 4 µm, 6 µm, 8 µm, 10 µm, 15 µm, 18 µm, 20 µm, 28 µm, 35 µm, or the like; a thickness of the first protective layer may be 2 µm, 5 µm, 8 µm, 10 µm, 15 µm, or the like; and a thickness of the second protective layer may be 4 µm, 6 µm, 10 µm, 12 µm, 15 µm, 20 µm, 22 µm, 25 µm, 30 µm, 35 µm, or the like. It may be understood that the thicknesses of these film layers listed herein may be randomly combined. This is not limited in this embodiment of this application.

According to a second aspect, this application further provides a transduction apparatus, where the transduction apparatus includes a controller and any transducer provided in the foregoing embodiments; the controller is connected to the transducer, and is configured to provide a first electrical signal for the transducer; and the transducer is configured to emit a first sound wave based on the first electrical signal.

Optionally, the transducer is further configured to receive a second sound wave, and provide a second electrical signal for the controller based on the second sound wave. In this case, the controller is configured to generate an image based on the second electrical signal. It may be understood that the transduction apparatus provided in this application may not need to receive the second sound wave, and the controller may not be configured to generate an image. In this case, the first sound wave may be output as a vibration signal to another circuit for use by the another circuit.

Optionally, the controller is further configured to perform fingerprint recognition based on the image. It may be understood that the transduction apparatus provided in this application may not be configured to perform fingerprint recognition based on the image. For example, the controller may control the image to be displayed.

Optionally, the transduction apparatus includes a penetration layer, and both the first sound wave and the second sound wave pass through the penetration layer. For example, the penetration layer is a display screen, a glass layer, or a metal layer.

In addition, in the transduction apparatus provided in this embodiment of this application, some film layers of the transducer may be grounded, to implement an electromagnetic shielding function, reduce noise of the transduction apparatus, and increase a signal-to-noise ratio.

For example, when the second protective layer in the transducer is a conductor (for example, copper), the second protective layer may be grounded.

For another example, when the second protective layer in the transducer is a conductor (for example, copper), the transduction apparatus may further include a switch, and the second protective layer may be grounded by using the switch. In this case, the controller is connected to the switch, and the controller is configured to control the switch to be turned off in a phase in which the transducer emits the first sound wave and to be turned on in a phase in which the transducer receives the second sound wave. In this way, in the phase in which the transducer emits the first sound wave, interference caused by the second protective layer to a parasitic capacitance generated when the transducer emits the first sound wave is avoided, a difficulty in controlling the transducer by the controller to emit the first sound wave is reduced, and noise can be shielded to some extent in a process in which the transducer receives the second sound wave.

For still another example, when the transducer includes a second additional layer, a third additional layer, and a fourth additional layer, both the second additional layer and the fourth additional layer are insulated (for example, both the second additional layer and the fourth additional layer are adhesive), and both the third additional layer and the second protective layer are conductors (for example, both the third additional layer and the second protective layer are copper), both the third additional layer and the second protective layer are grounded by using the switch. In this case, the controller is connected to the switch, and the controller is still configured to control the switch to be turned off in the phase in which the transducer emits the first sound wave and to be turned on in the phase in which the transducer receives the second sound wave. In this way, in the phase in which the transducer emits the first sound wave, interference caused by the second protective layer to a parasitic capacitance generated when the transducer emits the first sound wave is avoided, a difficulty in controlling the transducer by the controller to emit the first sound wave is reduced, and noise can be shielded to some extent in a process in which the transducer receives the second sound wave. In addition, compared with a shielding effect in which only the second protective layer is grounded, when both the second protective layer and the third additional layer are grounded, the shielding effect is improved.

According to a third aspect, this application provides a terminal. The terminal may be a mobile phone, a tablet computer, or the like. The terminal includes the transduction apparatus according to the second aspect.

### BRIEF DESCRIPTION OF DRAWINGS

FIG. 1 is a diagram of ultrasonic fingerprint recognition according to an embodiment of this application;
FIG. 2 is a diagram of a structure of a transducer according to a related technology;
FIG. 3 is a diagram of a structure of another transducer according to a related technology;
FIG. 4 is a diagram of a structure of a transducer according to an embodiment of this application;
FIG. 5 is a diagram of a structure of another transducer according to an embodiment of this application;
FIG. 6 is a diagram of a structure of another transducer according to an embodiment of this application;
FIG. 7 is a diagram of a structure of another transducer according to an embodiment of this application;
FIG. 8 is a diagram of a structure of another transducer according to an embodiment of this application;
FIG. 9 is a diagram of a structure of another transducer according to an embodiment of this application;
FIG. 10 is a diagram of a structure of another transducer according to an embodiment of this application;
FIG. 11 is a diagram of a working part of a transducer according to an embodiment of this application;
FIG. 12 is a diagram of a working part of another transducer according to an embodiment of this application;
FIG. 13 is a diagram of a working part of another transducer according to an embodiment of this application;
FIG. 14 is a diagram of a working part of another transducer according to an embodiment of this application;
FIG. 15 is a diagram of a working part of another transducer according to an embodiment of this application;
FIG. 16 is a diagram of a working part of another transducer according to an embodiment of this application;
FIG. 17 is a diagram of a working part of another transducer according to an embodiment of this application;
FIG. 18 is a diagram of a working part of another transducer according to an embodiment of this application;
FIG. 19 is a diagram of a working part of another transducer according to an embodiment of this application;
FIG. 20 is a diagram of a working part of another transducer according to an embodiment of this application;
FIG. 21 is a diagram of a working part of another transducer according to an embodiment of this application;
FIG. 22 is a diagram of a transduction apparatus according to an embodiment of this application;
FIG. 23 is a diagram of a structure of another transducer according to an embodiment of this application;
FIG. 24 is a diagram of a structure of another transducer according to an embodiment of this application;
FIG. 25 is a diagram of a structure of another transducer according to an embodiment of this application;
FIG. 26 is a diagram of a structure of another transducer according to an embodiment of this application;
FIG. 27 is a diagram of a structure of another transducer according to an embodiment of this application; and
FIG. 28 is a diagram of a structure of another transducer according to an embodiment of this application.

### DESCRIPTION OF EMBODIMENTS

To make principles and technical solutions of this application clearer, the following further describes implementations of this application in detail with reference to the accompanying drawings.

With rapid development of terminals (such as a mobile phone or a computer), fingerprint recognition technologies are more widely applied to the terminals, and the fingerprint recognition technologies may be used for implementing functions such as unlocking and making payment.

Currently, the fingerprint recognition technologies are classified into three types: capacitive fingerprint recognition, optical fingerprint recognition, and ultrasonic fingerprint recognition. The capacitive fingerprint recognition technology is the most mature. However, in the capacitive fingerprint recognition technology, due to a poor penetration capability, a thick medium (for example, a display screen) cannot be penetrated to recognize a fingerprint, and therefore, this technology is gradually eliminated. Optical fingerprint recognition has a strong penetration capability, and a display screen can be penetrated to obtain a fingerprint image. However, optical fingerprint recognition heavily depends on a transmittance of the display screen. As the display screen continuously evolves towards a direction of a low transmittance or even completely opaque due to a requirement such as resolution improvement, the optical fingerprint recognition technology also faces a crisis. Ultrasonic fingerprint recognition has a strong penetration capability, has no special requirement on a transmittance of a display screen, can implement three-dimensional fingerprint recognition, has a strong anti-interference capability, and therefore has a broad application prospect.

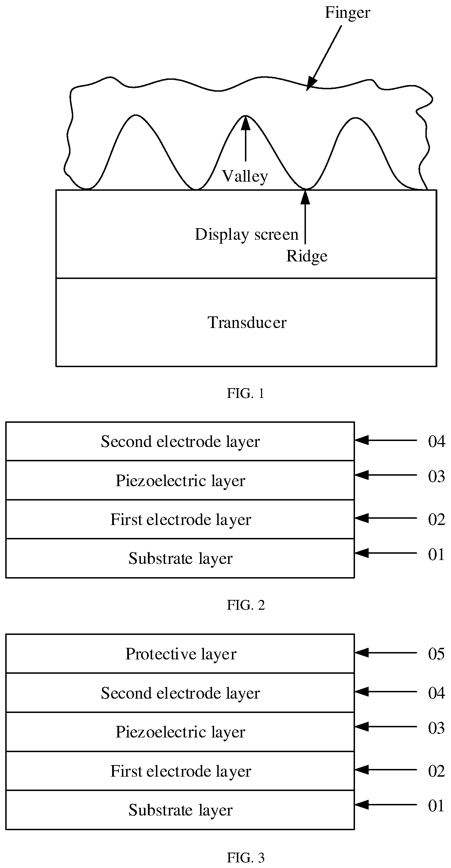

A principle of ultrasonic fingerprint recognition is shown in FIG. 1. A transducer emits an ultrasonic wave, and the ultrasonic wave penetrates a medium (such as a display screen) to reach a surface (with a fingerprint) that is in contact with a finger and that is in the medium. The fingerprint of the finger has a valley and a ridge, and the ultrasonic wave is reflected back to the transducer at air between the valley and the medium and at a skin tissue at the ridge. Because acoustic impedances of the air between the valley and the medium and the skin tissue at the ridge are different (an acoustic impedance of the medium = a density of the medium * a sound velocity of the sound wave in the medium), reflectivity of the ultrasonic wave in regions in which the valley and the ridge are located is different, and signal strength of the ultrasonic waves reflected back to the transducer is different. In this way, the valley and the ridge of the fingerprint can be recognized by detecting strength of ultrasonic signals returned at the different positions, thereby implementing fingerprint recognition.

The transducer is a device that can convert between electric energy and mechanical energy. The transducer can convert between electric energy and mechanical energy based on a piezoelectric effect. In a related technology, as shown in FIG. 2, the transducer includes a substrate layer 01, and a first electrode layer 02, a piezoelectric layer 03, and a second electrode layer 04 that are sequentially formed at the substrate layer 01. When an electrical signal is loaded between the first electrode layer 02 and the second electrode layer 04, the piezoelectric layer 03 located between the first electrode layer 02 and the second electrode layer 04 can vibrate under an action of the electrical signal, to emit a sound wave (for example, the foregoing ultrasonic wave) outwards. In addition, when the piezoelectric layer 03 receives a sound wave (for example, the foregoing ultrasonic wave reflected back) from the outside, the piezoelectric layer 03 can generate an electrical signal based on the sound wave. The electrical signal may be transmitted to the outside of the transducer through the first electrode layer 02 and the second electrode layer 04.

For example, when the transducer emits a sound wave, the first electrode layer 02 may be grounded, the second electrode layer 04 is not grounded, the second electrode layer 04 is configured to provide an electrical signal, and the piezoelectric layer 03 converts the electrical signal into a sound wave based on an inverse piezoelectric effect; and when the transducer receives a sound wave, the second electrode layer 04 may be grounded, the first electrode layer 02 is not grounded, the piezoelectric layer 03 converts the sound wave into an electrical signal based on a positive piezoelectric effect, and the first electrode layer 02 is configured to receive the electrical signal.

In the ultrasonic fingerprint recognition technology, a medium that needs to be penetrated by an ultrasonic wave is a display screen, and the display screen is formed by complex stacking layers. Therefore, an ultrasonic wave emitted by a transducer needs to have strong penetration power. Because the penetration power of the ultrasonic wave is related to an operating frequency of the ultrasonic wave, and the operating frequency of the ultrasonic wave is related to a thickness of a working part in the transducer that emits the ultrasonic wave, the thickness of the working part in the transducer can be properly designed based on required penetration power, so that the transducer can emit an ultrasonic wave at the corresponding operating frequency. It may be understood that the working part is further configured to receive a sound wave at the operating frequency, and convert the sound wave into an electrical signal.

For example, for the transducer shown in FIG. 2, both sides of the piezoelectric layer 03 in the transducer have a strong reflection boundary for a sound wave. For example, on a side of the piezoelectric layer 03 close to the first electrode layer 02, the strong reflection boundary is located on a surface of the piezoelectric layer 03 away from the second electrode layer 04; and on a side of the piezoelectric layer 03 close to the second electrode layer 04, the strong reflection boundary is located on a surface of the second electrode layer 04 away from the piezoelectric layer 03. The working part of the transducer is located between the two strong reflection boundaries. A sound wave emitted by the piezoelectric layer 03 can be reflected on the two strong reflection boundaries, resonance occurs on the two strong reflection boundaries for a sound wave at a specific frequency, and the resonance can greatly increase strength of the sound wave (for example, the foregoing ultrasonic wave). The transducer in this application may be referred to as a piezoelectric resonator.

An acoustic impedance difference between mediums on two adjacent sides of the strong reflection boundary is large. For example, an acoustic impedance of a medium adjacent to a side of a strong reflection boundary close to the piezoelectric layer is greater than twice an acoustic impedance of a medium adjacent to a side of the strong reflection boundary away from the piezoelectric layer, or is less than one half of an acoustic impedance of a medium adjacent to a side of the strong reflection boundary away from the piezoelectric layer. A sum of target parameters of film layers between two strong reflection boundaries is equal to an integer multiple of 0.25. A target parameter of any film layer in the transducer is a ratio of a thickness of the film layer to a wavelength of a sound wave at the operating frequency of the transducer when the sound wave is transmitted at the film layer. The wavelength of the sound wave at the operating frequency of the transducer when the sound wave is transmitted at the film layer is a ratio of a sound velocity of the sound wave at the operating frequency of the transducer when the sound wave is transmitted at the film layer to a frequency of the sound wave. Herein, the sound velocity of the sound wave at the operating frequency of the transducer when the sound wave is transmitted at the film layer may be a longitudinal wave sound velocity, a transverse wave sound velocity, or a guided-wave sound velocity. Therefore, the wavelength of the sound wave at the operating frequency of the transducer when the sound wave is transmitted at the film layer is: a ratio of a longitudinal wave sound velocity of the sound wave at the operating frequency of the transducer when the sound wave is transmitted at the film layer to the frequency of the sound wave at the operating frequency of the transducer; or a ratio of a transverse wave sound velocity of the sound wave at the operating frequency of the transducer when the sound wave is transmitted at the film layer to the frequency of the sound wave at the operating frequency of the transducer; or a ratio of a guided-wave sound velocity of the sound wave at the operating frequency of the transducer when the sound wave is transmitted at the film layer to the frequency of the sound wave at the operating frequency of the transducer.

In a fingerprint recognition scenario, the transducer usually needs to emit a sound wave at an operating frequency of 13 megahertz (MHz) or about 13 megahertz. In this case, the operating frequency is 13 megahertz. If a thickness of the first electrode layer and a thickness of the second electrode layer remain unchanged, and a thickness of the piezoelectric layer is adjusted, so that the sum of the target parameters of the film layers between the two strong reflection boundaries reaches an integer multiple of 0.25, and the thickness of the piezoelectric layer needs to be designed to be large (for example, 30 micrometers). However, a larger thickness of the piezoelectric layer indicates higher process difficulties and costs.

In a related technology, to reduce process difficulties and costs, as shown in FIG. 3, a protective layer 05 (an adhesive layer) is usually disposed on a side of the second electrode layer away from the piezoelectric layer, and a strong reflection boundary of a side on which the second electrode layer 04 is located is disposed as a surface of the protective layer 05 away from the piezoelectric layer 03. In this way, when the thickness of the working part in the transducer remains unchanged, the thickness of the piezoelectric layer can be reduced due to addition of the protective layer. In addition, the protective layer can further prevent the second electrode layer from being oxidized, and can additionally provide a cushioning protection function.

However, in a related technology, the thickness of the second electrode layer is still large, and consequently, process difficulties and costs are still high.

In addition, the second electrode layer usually uses a silver paste electrode layer, the piezoelectric layer usually uses a poly(vinylidene fluoride-trifluoroethylene) (PVDF-TRFE) film, and the protective layer usually uses a die attach film (die attach film, DAF). An acoustic impedance of the silver paste electrode layer is about 8 MRayl (MRayl), an acoustic impedance of PVDF-TRFE is about 4 MRayl, and an acoustic impedance of DAF is similar to that of PVDF-TRFE. It can be learned that, a difference between the acoustic impedance of the silver paste electrode layer and the acoustic impedance of each of the PVDF-TRFE and the DAF is large. Consequently, strong internal reflection of a sound wave is caused between the second electrode layer and the piezoelectric layer or between the second electrode layer and the protective layer, and energy of a sound wave at the operating frequency emitted by the transducer is low, thereby reducing sensitivity of the transducer.

In addition, generally, a strong reflection boundary also exists on a side of the substrate layer away from the piezoelectric layer. In this case, strong reflection of a sound wave also exists on the strong reflection boundary. In addition, the reflection also causes low energy of the sound wave at the operating frequency emitted by the transducer, thereby reducing sensitivity of the transducer.

In addition, the protective layer is usually an adhesive layer, and acoustic damping of the adhesive layer is usually high, which damages sensitivity of the transducer.

A theory that a sum of target parameters of film layers between two strong reflection boundaries reaches an integer multiple of 0.25 is actually applicable only to a case in which a material between the two strong reflection boundaries is a single material. When there are film layers of a plurality of materials between two strong reflection boundaries, a sum of target parameters of the film layers between the two strong reflection boundaries reaching an integer multiple of 0.25 causes a specific deviation in the operating frequency of the transducer.

In addition, a structure of the transducer (the substrate layer, the first electrode layer, the piezoelectric layer, the second electrode layer, and the protective layer) in the related technology has a single feasible implementation.

This application provides a transducer. An implementation of a structure of the transducer is different from the implementation shown in FIG. 3. Therefore, feasible implementations of the structure of the transducer are enriched. In addition, sensitivity of the transducer may be high, a deviation in an operating frequency may be small, a thickness of each film layer in the transducer is also low, and process difficulties and costs of the transducer are both low, thereby resolving problems of low performance and high costs of the transducer in the related technology. It may be understood that the transducer provided in this application is configured to emit a sound wave (for example, an ultrasonic wave or a non-ultrasonic wave), and the transducer may also receive a sound wave and convert the sound wave into an electrical signal. The transducer may be used for fingerprint recognition, or may not be used for fingerprint recognition.

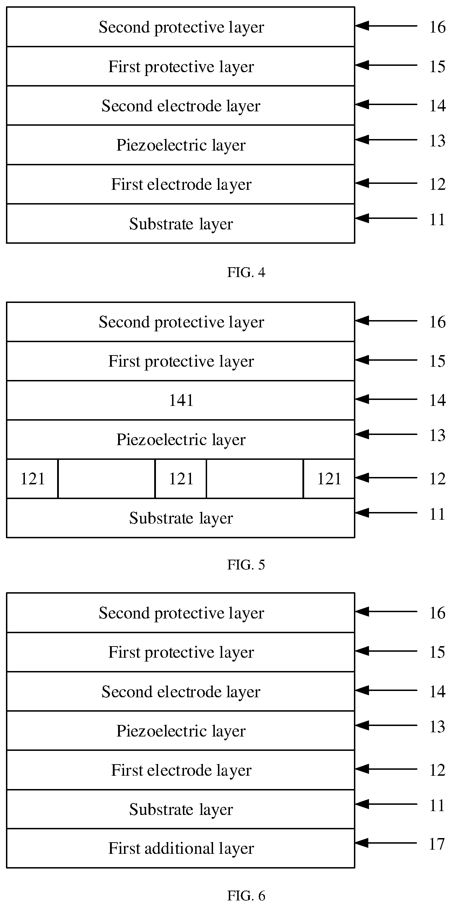

For example, FIG. 4 is a diagram of a structure of a transducer according to an embodiment of this application. As shown in FIG. 4, the transducer includes a substrate layer 11, a first electrode layer 12, a piezoelectric layer 13, a second electrode layer 14, a first protective layer 15, and a second protective layer 16 that are sequentially arranged.

The substrate layer 11 may be insulated or may not be insulated. The substrate layer 11 mainly plays a role of supporting an overall structure, and a material thereof may be a rigid material (for example, glass or silicon) or a flexible material (for example, a polymer material such as polyimide PI or PET).

The first protective layer 15 may be insulated or may not be insulated, the second protective layer 16 may be insulated or may not be insulated, and materials of the first protective layer 15 and the second protective layer 16 are different. This is not limited in this application. Compared with the transducer shown in FIG. 3, in the transducer shown in FIG. 4, there are two protective layers on a side of the second electrode layer 14 away from the piezoelectric layer 13, and materials of the two protective layers are different. In this way, feasible implementations of the structure of the transducer are enriched.

Materials of the first protective layer 15 and the second protective layer 16 are not limited in embodiments of this application, provided that materials of the first protective layer 15 and the second protective layer 16 are different. In an optional implementation, a material of one of the first protective layer 15 and the second protective layer 16 includes adhesive, in other words, this protective layer is an adhesive layer. For example, the first protective layer 15 is an adhesive layer, or the second protective layer 16 is an adhesive layer. For example, the material of this protective layer may be various polymer materials, for example, an adhesive material such as an optically clear adhesive (optically clear adhesive, OCA) or a pressure-sensitive adhesive (pressure sensitive adhesive, PSA).

Optionally, when a material of one of the first protective layer 15 and the second protective layer 16 includes adhesive, acoustic damping of the other of the first protective layer 15 and the second protective layer 16 is less than acoustic damping of this protective layer, and/or roughness of a surface of a side of the other protective layer away from the piezoelectric layer 13 is less than roughness of a surface of a side of this protective layer away from the piezoelectric layer 13. For example, a material of the other protective layer includes metal (for example, aluminum (Al), gold (Au), silver (Ag), platinum (Pt), copper (Cu), molybdenum (Mo), or titanium (Ti)), and the material of the other protective layer may alternatively be non-metal. This is not limited in this application.

When one of the first protective layer and the second protective layer is an adhesive layer, and acoustic damping of the other protective layer is less than acoustic damping of this protective layer (the adhesive layer), overall acoustic damping of the first protective layer and the second protective layer is less than overall acoustic damping of the first protective layer and the second protective layer when both the first protective layer and the second protective layer are adhesive layers. In addition, when the overall acoustic damping of the first protective layer and the second protective layer is small, and the first protective layer and the second protective layer belong to the working part of the transducer, an overall loss of the sound wave at the first protective layer and the second protective layer is small, so that sensitivity of the transducer can be improved.

In addition, a rougher surface on which the strong reflection boundary is located indicates greater noise of the transducer. When roughness of a surface of a side of the second protective layer 16 away from the piezoelectric layer 13 is less than roughness of a surface of a side of the first protective layer 15 away from the piezoelectric layer 13, and the first protective layer 15 is an adhesive layer, if the surface of the side of the second protective layer 16 away from the piezoelectric layer 13 is a strong reflection boundary, noise of the transducer can be small. However, for the transducer shown in FIG. 3, if a surface of a side of the protective layer 05 away from the piezoelectric layer 03 is a strong reflection boundary, noise of the transducer is large because roughness of the surface is large.

The first protective layer 15 and the second protective layer 16 can further prevent the second electrode layer 14 from being oxidized, and can additionally provide a cushioning protection function.

In this application, for example, a material of one of the first protective layer and the second protective layer includes adhesive, and a material of the other protective layer includes metal. For example, the material of the first protective layer includes adhesive, and the material of the second protective layer includes metal. The material of the first protective layer may alternatively be not limited to adhesive. For example, the material of the first protective layer may be a polymer different from adhesive. The material of the second protective layer may alternatively be not limited to metal, and the material of the second protective layer may alternatively be non-metal. It may be understood that at least one of the first protective layer and the second protective layer may alternatively not belong to a working part of the transducer.

The first protective layer and the second protective layer may be implemented by using a one-step lamination process. For example, when the first protective layer is an adhesive layer, and the second protective layer is a copper layer, the first protective layer and the second protective layer may use a copper adhesive tape that includes an adhesive layer and a copper layer. In this case, the copper adhesive tape may be directly formed, through one-step lamination, on a surface of the second electrode layer away from the substrate layer. Certainly, the first protective layer and the second protective layer may alternatively not be formed at the same time. For example, an adhesive layer is first laminated on the surface of the second electrode layer away from the substrate layer, to form the first protective layer, and then a metal layer is formed on a surface of the adhesive layer by using a process such as sputtering or evaporation, to form the second protective layer.

As shown in FIG. 5, the first electrode layer 12 may include a plurality of first electrode blocks 121 arranged in an array, the second electrode layer 14 includes a second electrode block 141, an orthographic projection of the second electrode block 141 at the substrate layer 11 and an orthographic projection of the piezoelectric layer 13 at the substrate layer have an overlapping region, and all orthographic projections of the plurality of first electrode blocks 121 at the substrate layer 11 are located in the overlapping region. It can be learned that the first electrode layer 12 may be a pixelated electrode layer, and the first electrode block 121 at the first electrode layer 12 may be referred to as a pixel electrode. A region in which each first electrode block 121 in the transducer is located is one transduction region, and a plurality of transduction regions in the transducer can perform transduction independently of each other.

When the first electrode layer 12 includes the plurality of first electrode blocks 121 arranged in an array, the transducer may be configured to implement fingerprint recognition. A thickness of the first electrode layer 12 is usually very small (on a nanometer scale) to reduce impact on flatness of the piezoelectric layer 13 (which may be deposited on a surface of the first electrode layer 12). A material of the first electrode layer 12 may be various conductive materials, including a metal material (for example, Al, Au, Ag, Pt, Cu, Mo, or Ti), a conductive polymer material (for example, indium tin oxide), or the like.

It may be understood that alternatively the first electrode layer 12 may not be a pixelated electrode layer. For example, the first electrode layer 12 includes only one first electrode block 121, and the transducer includes one transduction region in which the first electrode block 121 is located. This is not limited in this application.

A material of the piezoelectric layer 13 may be an organic polymer material, for example, PVDF and a copolymer thereof PVDF-TRFE or a blend PVDF-graphene; or a material of the piezoelectric layer 13 may be a piezoelectric ceramic material, for example, lead zirconate titanate piezoelectric ceramics (lead zirconate titanate piezoelectric ceramics, PZT) and an alloy material thereof (for example, lead lanthanum zirconium titanate (PLZT), lead magnesium niobate (PNZT), sodium potassium niobate (KₓNa₁₋ₓNbO₃, KNN), or lead titanium magnesium acid (PMN-PT) with a calcium titanium phase structure); or a material of the piezoelectric layer 13 may be an inorganic piezoelectric material, for example, aluminum nitride (AlN) and an alloy material thereof (for example, ScₓAl₁₋ₓN) and zinc oxide (ZnO) and an alloy material thereof (VₓZn₁₋ₓO), where 0<x< 1.

A material of the second electrode layer 14 may be various conductive materials (for example, Al, Au, Ag, Pt, Cu, Mo, or Ti), a conductive polymer material (for example, indium tin oxide), or the like. In addition, to reduce an acoustic impedance thereof, the second electrode layer may alternatively be a conductive adhesive layer formed by mixing metal powder and a polymer material, for example, a silver paste layer. However, in this case, to ensure conductivity thereof, a thickness (at a micrometer level) thereof usually needs to be increased.

A thickness of each film layer in the transducer provided in this application may be set as required. For example, the thickness of each film layer in the transducer may be set based on the operating frequency (also referred to as a resonant frequency) of the transducer. For example, a thickness of the substrate layer may be 50 micrometers (µm), 70 µm, 90 µm, 120 µm, 150 µm, 200 µm, 250 µm, 300 µm, or the like; a thickness of the piezoelectric layer may be 5 µm, 7 µm, 9 µm, 11 µm, 15 µm, 20 µm, or the like; a thickness of the second electrode layer may be 2 µm, 4 µm, 6 µm, 8 µm, 10 µm, 15 µm, 18 µm, 20 µm, 28 µm, 35 µm, or the like; a thickness of the first protective layer may be 2 µm, 5 µm, 8 µm, 10 µm, 15 µm, or the like; and a thickness of the second protective layer may be 4 µm, 6 µm, 10 µm, 12 µm, 15 µm, 20 µm, 22 µm, 25 µm, 30 µm, 35 µm, or the like. It may be understood that the thicknesses of these film layers listed herein may be randomly combined. This is not limited in this embodiment of this application.

The transducer provided in this application includes a plurality of film layers, such as the substrate layer 11, the first electrode layer 12, the piezoelectric layer 13, the second electrode layer 14, the first protective layer 15, and the second protective layer 16. On a basis of implementing a basic function (transduction) of the transducer, there may be at least one first film layer in these film layers. An acoustic impedance of the piezoelectric layer 13 differs greatly from an acoustic impedance of the first film layer in the transducer. For example, the acoustic impedance of the piezoelectric layer 13 is greater than twice the acoustic impedance of the first film layer in the transducer, or the acoustic impedance of the piezoelectric layer 13 is less than one half of the acoustic impedance of the first film layer. In addition, a target parameter of the first film layer is less than one tenth. In this application, for example, at least one film layer of the first electrode layer 12, the second electrode layer 14, the first protective layer 15, and the second protective layer 16 is a first film layer, or the first protective layer 15 is a first film layer. For example, when the second electrode layer 14 is a first film layer, the acoustic impedance of the piezoelectric layer 13 is greater than twice an acoustic impedance of the second electrode layer 14, or the acoustic impedance of the piezoelectric layer 13 is less than one half of the acoustic impedance of the second electrode layer 14; and the target parameter of the second electrode layer 14 is less than one tenth. For another example, when the second protective layer 16 is a first film layer, the acoustic impedance of the piezoelectric layer 13 is greater than twice an acoustic impedance of the second protective layer 16, or the acoustic impedance of the piezoelectric layer 13 is less than one half of the acoustic impedance of the second protective layer 16; and the target parameter of the second protective layer 16 is less than one tenth. For another example, when both the second electrode layer 14 and the second protective layer 16 are first film layers, the acoustic impedance of the piezoelectric layer 13 is greater than twice the acoustic impedance of the second electrode layer 14, or the acoustic impedance of the piezoelectric layer 13 is less than one half of the acoustic impedance of the second electrode layer 14; or the acoustic impedance of the piezoelectric layer 13 is greater than twice the acoustic impedance of the second protective layer 16, or the acoustic impedance of the piezoelectric layer 13 is less than one half of the acoustic impedance of the second protective layer 16; and the target parameter of the second electrode layer 14 is less than one tenth, and the target parameter of the second protective layer 16 is less than one tenth.

It can be learned that a difference between the acoustic impedance of the first film layer and the acoustic impedance of the piezoelectric layer is large. In this case, in this application, a thickness of the first film layer is reduced, so that the target parameter of the first film layer is less than one tenth, and the first film layer is used as an acoustically transparent layer. In this way, when the first film layer belongs to the working part of the transducer, a material of a film layer other than the first film layer and the piezoelectric layer in the working part may be set as a material with a small acoustic impedance difference from the piezoelectric layer, so that acoustic impedances of film layers in the working part are similar, reflection of a sound wave in the working part is reduced, and sensitivity of the transducer is improved.

When the first electrode layer or the second electrode layer is a first film layer, a thickness of the first electrode layer or the second electrode layer is thin, and process difficulties and costs of producing the first electrode layer or the second electrode layer may be low.

For example, the first electrode layer 12, the second electrode layer 14, and the second protective layer 16 are all first film layers. In this case, the piezoelectric layer 13 may use a first piezoelectric material with a small acoustic impedance (for example, less than 5 MRayl), materials of the first electrode layer 12, the second electrode layer 14, and the second protective layer 16 may all be metal with a large acoustic impedance, and the first protective layer 15 may be an adhesive layer with a small acoustic impedance. In addition, two strong reflection boundaries on two sides of the piezoelectric layer may be respectively located on a surface of the substrate layer 11 close to the piezoelectric layer 13 and a surface of the second protective layer 16 away from the piezoelectric layer 13. Because an acoustic impedance of metal is large, a difference between the acoustic impedance and the acoustic impedance of the first piezoelectric material is usually large. Therefore, thicknesses of the first electrode layer 12, the second electrode layer 14, and the second protective layer 16 whose materials are all metal are reduced, so that all these film layers are used as acoustically transparent layers. In this case, acoustic impedances of film layers other than the acoustically transparent layers in a working part between the two strong reflection boundaries are similar, so that reflection of a sound wave in the working part can be reduced, and sensitivity of the transducer can be improved.

For example, when the transducer includes the substrate layer, the first electrode layer, the piezoelectric layer, the second electrode layer, the first protective layer, and the second protective layer, the substrate layer may use a glass material, the second electrode layer uses a silver paste material, the second protective layer uses a copper material, the piezoelectric layer uses a PVDF-TRFE material, the first protective layer uses an OCA or PSA adhesive material, and the first electrode layer, the second electrode layer, and the second protective layer are all first film layers.

For another example, the first protective layer 15 is a first film layer. In this case, the piezoelectric layer 13 may use a second piezoelectric material with a large acoustic impedance (for example, greater than 10 MRayl), materials of the first electrode layer 12, the second electrode layer 14, and the second protective layer 16 may all be metal with a large acoustic impedance, and the first protective layer 15 may be an adhesive layer with a small acoustic impedance. In addition, two strong reflection boundaries on two sides of the piezoelectric layer may be respectively located on a surface of the substrate layer 11 close to the piezoelectric layer 13 and a surface of the second protective layer 16 away from the piezoelectric layer 13. Because a difference between an acoustic impedance of an adhesive layer and the acoustic impedance of the second piezoelectric material is usually large, a thickness of the first protective layer 15 using an adhesive layer is reduced, so that the first protective layer 15 is used as an acoustically transparent layer. In this case, acoustic impedances of film layers other than the acoustically transparent layers in a working part between the two strong reflection boundaries are similar, so that reflection of a sound wave in the working part can be reduced, and sensitivity of the transducer can be improved.

The operating frequency of the transducer is mentioned in the foregoing content. It may be understood that the operating frequency is selected mainly based on two points: 1. a resolution required by a scenario, where for a fingerprint imaging scenario, to implement differentiation between a valley and a ridge of a fingerprint, a higher frequency indicates a higher resolution; and 2. a penetrable thickness, where a higher sound wave frequency indicates higher attenuation, and therefore, to ensure sufficient echo strength, a maximum resonant frequency is usually limited. Therefore, in an under-screen fingerprint recognition scenario, the operating frequency is usually 5 megahertz to 25 megahertz (for example, 5 megahertz to 15 megahertz). In this embodiment of this application, for example, the operating frequency is 13 megahertz.

In the foregoing content, for example, the transducer includes the substrate layer 11, the first electrode layer 12, the piezoelectric layer 13, the second electrode layer 14, the first protective layer 15, and the second protective layer 16 that are sequentially arranged. Optionally, the transducer may further include another film layer.

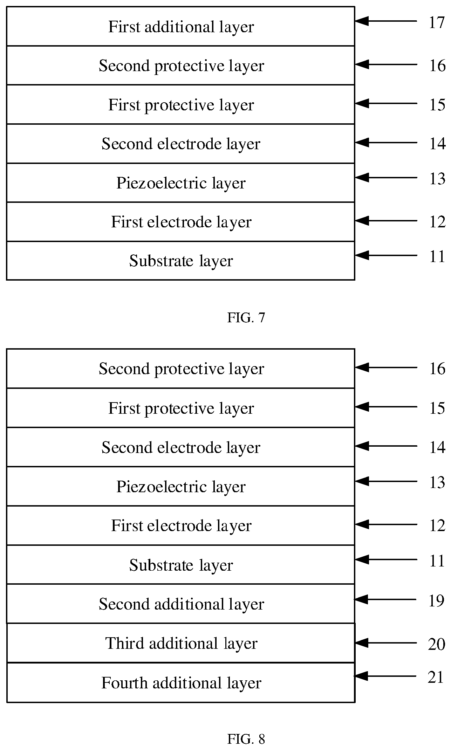

In an optional implementation, as shown in FIG. 6, the transducer further includes a first additional layer 17, and the first additional layer 17 is located on a side of the substrate layer 11 away from the piezoelectric layer 13. Alternatively, as shown in FIG. 7, the first additional layer 17 may be located on a side of the second protective layer 16 away from the piezoelectric layer 13. A material of the first additional layer 17 is not limited in this application. For example, the material of the first additional layer 17 is adhesive, and the first additional layer 17 is also an adhesive layer.

In another optional implementation, the transducer further includes a second additional layer, a third additional layer, and a fourth additional layer, where the second additional layer is located on the side of the substrate layer away from the piezoelectric layer. The second additional layer, the third additional layer, and the fourth additional layer are sequentially arranged on the side of the substrate layer away from the piezoelectric layer in a direction away from the substrate layer. For example, the transducer that further includes a second additional layer 19, a third additional layer 20, and a fourth additional layer 21 may be shown in FIG. 8. For example, both the second additional layer and the fourth additional layer include adhesive, the third additional layer includes copper, both the second additional layer and the fourth additional layer may be adhesive layers, and the third additional layer may be a copper layer. In this way, an entirety including the second additional layer, the third additional layer, and the fourth additional layer may be a copper adhesive tape. It may be understood that there are two types of copper adhesive tapes in this application. In one type of copper adhesive tape, there is an adhesive layer on both sides of the copper layer, and in the other type of copper adhesive tape, there is an adhesive layer on one side of the copper layer, and there is no adhesive layer on the other side.

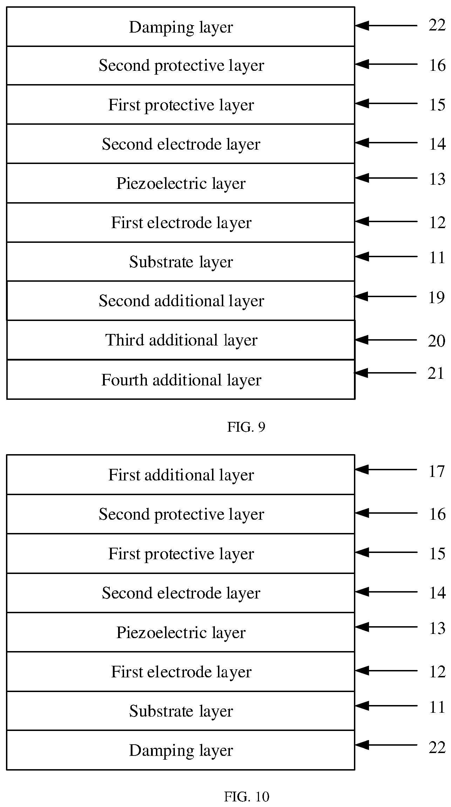

Optionally, the transducer further includes a damping layer. The damping layer is a film layer located on an outer side of the transducer, and acoustic damping of the damping layer is greater than acoustic damping of an adjacent film layer of the damping layer in the transducer. For example, on a basis of FIG. 8, the transducer that further includes a damping layer 22 may be shown in FIG. 9. On a basis of FIG. 7, the transducer that further includes a damping layer 22 may be shown in FIG. 10.

When the transducer includes a damping layer, under an effect that acoustic damping of the damping layer is greater than acoustic damping of an adjacent film layer, sound energy output by the transducer can be attenuated quickly, and an oscillation attenuation time of the transducer is reduced. Because the oscillation attenuation time of the transducer is negatively correlated with a bandwidth, a bandwidth of the transducer can be increased. It can be learned that, disposing the damping layer in the transducer can increase a bandwidth of a sound wave emitted by the transducer.

Optionally, the transducer further includes a circuit layer (not shown in the figure) located between the substrate layer 11 and the first electrode layer 12, and the circuit layer is connected to the first electrode layer 12. The circuit layer is configured to process (preprocess) an electrical signal generated by the piezoelectric layer based on a received sound wave, and then output a processed electrical signal to the outside of the transducer. The circuit layer may include a device configured to form a circuit, for example, a thin film transistor (thin film transistor, TFT) (or a complementary metal oxide semiconductor (complementary metal oxide semiconductor, CMOS)), a capacitor, an inductor, or a resistor. When the substrate layer uses a glass material, the circuit layer may include a TFT. When the substrate layer uses a silicon material, the circuit layer may include a CMOS. The circuit layer may include an application-specific integrated circuit (application-specific integrated circuit, ASIC), and the foregoing devices such as the TFT, the CMOS, the capacitor, the inductor, and the resistor may all belong to the ASIC.

Optionally, the transducer further includes an auxiliary adhesion layer (not shown in the figure) located between the first electrode layer 12 and the piezoelectric layer 13. A bonding force between the auxiliary adhesion layer and the first electrode layer 12 and a bonding force between the auxiliary adhesion layer and the piezoelectric layer 13 are both greater than a bonding force between the first electrode layer 12 and the piezoelectric layer 13. In this way, compared with direct contact between the first electrode layer 12 and the piezoelectric layer 13, when the auxiliary adhesion layer is disposed between the first electrode layer 12 and the piezoelectric layer 13, a bonding effect between the first electrode layer 12 and the piezoelectric layer 13 is better.

The transducer may further include another film layer in addition to the foregoing film layers. Details are not described herein in this application. In addition, the transducer may alternatively not include the at least one optional film layer.

In addition, a magnitude relationship between acoustic impedances of film layers in the transducer is not limited in this application. For example, a relationship between two acoustic impedances of any two film layers in the transducer may be as follows: A difference between the two acoustic impedances is large (for example, one acoustic impedance is greater than twice the other acoustic impedance, or one acoustic impedance is less than one half of the other acoustic impedance). Alternatively, the two acoustic impedances are similar (for example, one acoustic impedance is greater than a quarter of the other acoustic impedance and is less than four times the other acoustic impedance; or one acoustic impedance is greater than a quarter of the other acoustic impedance and is less than four times the other acoustic impedance).

The transducer provided in this application also has two strong reflection boundaries located on two sides of the piezoelectric layer, and a part that is in the transducer and that is located between the two strong reflection boundaries is a working part of the transducer. Positions of the two strong reflection boundaries are not limited in embodiments of this application, and correspondingly, composition of the working part is not limited.

The working part of the transducer is configured to emit a sound wave at the operating frequency of the transducer based on an electrical signal, and generate a corresponding electrical signal based on a received sound wave at the operating frequency. A thickness of the working part is related to the operating frequency.

For example, the transducer includes a film layer group, and the film layer group includes two film layers located on the two sides of the piezoelectric layer. For any one of the two film layers, a difference between an acoustic impedance of the any film layer and an acoustic impedance of a medium (which may belong to the transducer or may not belong to the transducer) adjacent to a side of the any film layer away from the piezoelectric layer is large. For example, the acoustic impedance of the any film layer is greater than twice the acoustic impedance of the medium (which may belong to the transducer or may not belong to the transducer, or may be gas (such as air) or may not be gas but a physical structure) adjacent to the side of the any film layer away from the piezoelectric layer; or the acoustic impedance of the any film layer is less than one half of the acoustic impedance of the medium adjacent to the side of the any film layer away from the piezoelectric layer. In this way, surfaces of sides of two film layers in each film layer group away from the piezoelectric layer are strong reflection boundaries, and the two film layers and a film layer therebetween can form one working part. Herein, for example, the film layer group includes the two film layers. It may be understood that the film layer group may also include a film layer between the two film layers. In this case, the film layer group forms one working part.

It may be understood that, one of the two film layers included in the film layer group may also be a piezoelectric layer, and the other film layer may be located on any side of the piezoelectric layer. An acoustic impedance of the piezoelectric layer and an acoustic impedance of a medium (which may belong to the transducer or may not belong to the transducer) adjacent to a side of the piezoelectric layer away from the other film layer is large. An acoustic impedance of the other film layer and an acoustic impedance of a medium (which may belong to the transducer or may not belong to the transducer) adjacent to a side of the other film layer away from the piezoelectric layer is large. For example, the acoustic impedance of the piezoelectric layer is greater than twice the acoustic impedance of the medium adjacent to the side of the piezoelectric layer away from the other film layer, or the acoustic impedance of the piezoelectric layer is less than one half of the acoustic impedance of the medium adjacent to the side of the piezoelectric layer away from the other film layer. The acoustic impedance of the other film layer is greater than twice the acoustic impedance of the medium adjacent to the side of the other film layer away from the piezoelectric layer; or the acoustic impedance of the other film layer is less than one half of the acoustic impedance of the medium adjacent to the side of the other film layer away from the piezoelectric layer.

A sum of target parameters of two film layers in each film layer group and a film layer between the two film layers is a positive integer multiple of n. In other words, a sum of target parameters of film layers in a working part including the two film layers and the film layer therebetween is a positive integer multiple of n. 0.1≤n≤0.4, and n = 0.25, or 0.25±0.15. For example, a sum of target parameters of two film layers in each film layer group and a film layer between the two film layers is a positive integer multiple of 0.25 (or 0.25±0.15). Because an acoustic impedance of each film layer in the working part of the transducer is different, partial internal reflection of a sound wave still exists in the working part. Therefore, in some cases, when a sum of target parameters of film layers in the working part deviates from an integer multiple of 0.25 (for example, an integer multiple of 0.25±0.15), the working part can still emit a sound wave at the operating frequency.

For example, when the transducer includes the substrate layer, the first electrode layer, the piezoelectric layer, the second electrode layer, the first protective layer, and the second protective layer that are sequentially arranged, a sum of target parameters of the piezoelectric layer, the second electrode layer, the first protective layer, and the second protective layer is a positive integer multiple of n. In this case, the two film layers in the film layer group are the piezoelectric layer and the second protective layer. A side of the piezoelectric layer away from the second protective layer is a strong reflection boundary, and a side of the second protective layer away from the piezoelectric layer is the other strong reflection boundary.

Further, in the foregoing embodiment, for example, the transducer includes one film layer group. In this application, the transducer may alternatively include a plurality of film layer groups, and at least one film layer in different film layer groups is different. Two film layers in each film layer group and a part therebetween form one working part corresponding to the film layer group. A plurality of film layer groups can form a plurality of corresponding working parts. The plurality of working parts are each configured to emit a sound wave at the operating frequency of the transducer. In this way, sensitivity of the transducer can be improved.

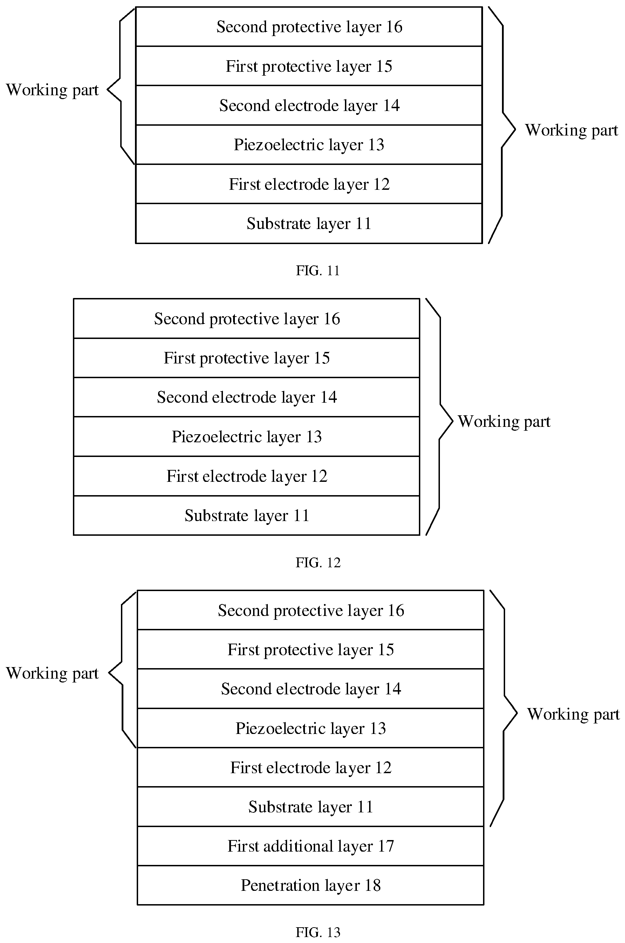

For example, the transducer shown in FIG. 11 includes two film layer groups. Two film layers in one film layer group (two film layers at edges of the film layer group) are a piezoelectric layer 13 and a second protective layer 16, and two film layers in the other film layer group (two film layers at edges of the film layer group) are a substrate layer 11 and a second protective layer 16. In this case, a sum of target parameters of the piezoelectric layer, the second electrode layer, the first protective layer, and the second protective layer is a positive integer multiple of n, and a sum of target parameters of the substrate layer, the first electrode layer, the piezoelectric layer, the second electrode layer, the first protective layer, and the second protective layer is a positive integer multiple of n.

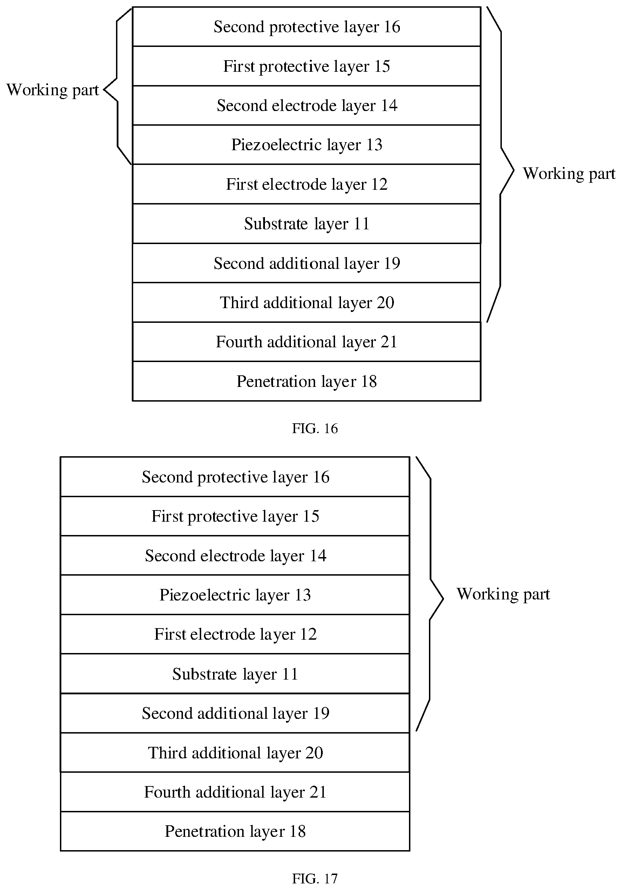

For another example, the transducer shown in FIG. 16 includes two film layer groups. Two film layers in one film layer group (two film layers at edges of the film layer group) are a piezoelectric layer and a second protective layer, and two film layers in the other film layer group (two film layers at edges of the film layer group) are a third additional layer and a second protective layer. In this case, a sum of target parameters of the piezoelectric layer, the second electrode layer, the first protective layer, and the second protective layer is a positive integer multiple of n, and a sum of target parameters of the third additional layer, the second additional layer, the substrate layer, the first electrode layer, the piezoelectric layer, the second electrode layer, the first protective layer, and the second protective layer is a positive integer multiple of n.

It can be learned that the transducer includes at least one film layer group, and two film layers in the film layer group are not limited in this application.

For example, the at least one film layer group includes at least one film layer of the piezoelectric layer and the second protective layer. For example, the two film layers in the film layer group include at least one film layer of the piezoelectric layer and the second protective layer. When the two film layers in the film layer group include the piezoelectric layer and the second protective layer, the piezoelectric layer, the second protective layer, and a film layer between the piezoelectric layer and the second protective layer form one working part, and a sum of target parameters of the film layers in the working part is an integer multiple of 0.25 (or 0.25±0.15).

For another example, the at least one film layer group includes at least one film layer of the substrate layer and the second protective layer. For example, the two film layers in the film layer group include at least one film layer of the substrate layer and the second protective layer. When the two film layers in the film layer group include the substrate layer and the second protective layer, the substrate layer, the second protective layer, and a film layer between the substrate layer and the second protective layer form one working part, and a sum of target parameters of film layers in the working part is an integer multiple of 0.25 (or 0.25±0.15).

For still another example, when the transducer includes the second additional layer, the third additional layer, and the fourth additional layer, the at least one film layer group includes the second additional layer or the third additional layer. For example, the film layer group includes the second additional layer or the third additional layer. When the two film layers in the film layer group include the second additional layer and the second protective layer, the second additional layer, the second protective layer, and a film layer between the second additional layer and the second protective layer form one working part, and a sum of target parameters of film layers in the working part is an integer multiple of 0.25 (or 0.25±0.15). When the two film layers in the film layer group include the third additional layer and the second protective layer, the third additional layer, the second protective layer, and a film layer between the third additional layer and the second protective layer form one working part, and a sum of target parameters of film layers in the working part is an integer multiple of 0.25 (or 0.25±0.15).

A plurality of features of the transducer are listed in the foregoing content. It may be understood that, on a basis that a transduction function of the transducer can be implemented, these features may be randomly combined as required. It can be learned that the transducer provided in this application may have at least one of the foregoing plurality of features.

The following describes the transducer provided in this application by using several examples.

**Example 1:** As shown in FIG. 11, the transducer includes a substrate layer 11, a first electrode layer 12, a piezoelectric layer 13, a second electrode layer 14, a first protective layer 15 (an adhesive layer), and a second protective layer 16 (a metal layer).

The substrate layer 11 uses a glass material, and the first electrode layer 12, the second electrode layer 14, and the second protective layer 16 all use a metal material (for example, copper or silver paste). The piezoelectric layer 13 uses a PVDF-TRFE material, and the first protective layer 15 uses an OCA or PSA adhesive material.

The piezoelectric layer 13 and the second protective layer 16 form one film layer group. A surface of a side of the piezoelectric layer 13 away from the second protective layer 16 is a strong reflection boundary, and a surface of a side of the second protective layer 16 away from the piezoelectric layer 13 is a strong reflection boundary. The piezoelectric layer 13, the second protective layer 16, and a film layer between the piezoelectric layer 13 and the second protective layer 16 form one working part, and a sum of target parameters of film layers in the working part is an integer multiple of 0.25 (or 0.25±0.15).

The first electrode layer 12 is an acoustically transparent layer, an acoustic impedance R1 of the piezoelectric layer 13 is about 4 MRayl, and an acoustic impedance R2 of the substrate layer 11 is about 13.5 MRayl. Based on a sound transmission theory, a sound energy reflection coefficient of the surface of the side of the piezoelectric layer 13 away from the second protective layer 16 is [(R2-R1)/(R2+R1)]²≈30%. It can be learned that the sound energy reflection coefficient is not small, the interface reflects some sound waves, and the interface may be considered as a strong sound reflection boundary. However, for the surface of the side of the second protective layer 16 away from the piezoelectric layer 13, because the side of the second protective layer 16 away from the piezoelectric layer 13 is usually air (not shown in the figure), and an acoustic impedance of air is approximately equal to 0, almost 100% of sound waves are reflected on the surface of the side of the second protective layer 16 away from the piezoelectric layer 13. Therefore, the surface of the side of the second protective layer 16 away from the piezoelectric layer 13 is also considered as a strong sound reflection boundary.

Further, based on the foregoing solution, the substrate layer and the second protective layer form another film layer group. A surface of a side of the substrate layer away from the piezoelectric layer is a strong reflection boundary, and a surface of a side of the second protective layer away from the piezoelectric layer is a strong reflection boundary. In this case, the substrate layer, the second protective layer, and a film layer between the substrate layer and the second protective layer form one working part, and a sum of target parameters of film layers in the working part is an integer multiple of 0.25 (or 0.25±0.15). It can be learned that the transducer in this example includes two film layer groups, so that the transducer has two working parts corresponding to the two film layer groups.

It can be learned from the sound energy reflection coefficient being about 30% in the foregoing content that, about 70% of sound waves penetrate into the substrate layer from the piezoelectric layer 13. Therefore, the substrate layer and the second protective layer form one film layer group, so that a working part corresponding to the film layer group can also perform resonance enhancement on these sound waves.

It is found through simulation that, when not all sums of target parameters of film layers in a plurality of working parts are integer multiples of 0.25 (or 0.25±0.15), not all the plurality of working parts emit a sound wave at the operating frequency, resulting in a significant decrease in sensitivity and a signal-to-noise ratio of the transducer. In a scenario in which the transducer is used for fingerprint recognition, an effect of fingerprint recognition is greatly reduced. However, in this application, sums of target parameters of film layers in a plurality of working parts are integer multiples of 0.25 (or 0.25±0.15). Therefore, both sensitivity and the signal-to-noise ratio of the transducer are high, and the effect of fingerprint recognition can be improved.

Further, for a part between film layer groups, reflection of each interface in the part needs to be reduced as much as possible, to improve performance of the transducer. There are usually two manners to reduce internal reflection.

Manner 1: A material with a similar acoustic impedance is selected. For example, in this example, the first protective layer is set as an adhesive layer whose acoustic impedance is similar to that of the piezoelectric layer. For example, when the acoustic impedance of the piezoelectric layer is 4 MRayl, the first protective layer may use an OCA adhesive layer whose acoustic impedance is about 2.5 MRayl (close to 4 MRayl).

Manner 2: For a film layer whose acoustic impedance is greatly different from that of the piezoelectric layer, the film layer may be thinned, so that the film layer forms an acoustically transparent layer. For example, the acoustic impedances of the first electrode layer, the second electrode layer, and the second protective layer (metal layer) are usually greater than 10 MRayl (or even greater than 30 MRayl). Therefore, there are no cases in which the acoustic impedances of materials of these film layers are similar to the acoustic impedance of the piezoelectric layer. In such cases, these film layers may be thinned, so that target parameters of these film layers are less than one tenth.

It may be understood that alternatively the material of the substrate layer in Embodiment 1 may not be glass. For example, the material of the substrate layer may alternatively be silicon. An acoustic impedance (~30 MRayl) of silicon is also far greater than the acoustic impedance of the material of the piezoelectric layer (PVDF-TRFE). In this case, one strong reflection boundary is still formed on the side of the piezoelectric layer away from the second protective layer.

Example 2: The substrate layer 11 in Example 1 may alternatively use a flexible material. An acoustic impedance (about 3 MRayl) of the flexible material is close to the acoustic impedance of the piezoelectric layer 13 (a PVDF-TRFE material). Therefore, a strong reflection boundary cannot be formed between the substrate layer 11 and the piezoelectric layer 13. In this case, the piezoelectric layer 13 and the second protective layer 16 cannot form one film layer group, and the substrate layer 11 and the second protective layer 16 form one film layer group. As shown in FIG. 12, the substrate layer 11, the second protective layer 16, and a part between the substrate layer 11 and the second protective layer 16 form one working part, and a sum of target parameters of film layers in the working part is a positive integer multiple of 0.25 (or 0.25±0.15).

Example 3: Based on Example 1, as shown in FIG. 13, the transducer further includes a first additional layer 17. A penetration layer 18 is disposed on a side of the first additional layer 17 away from the piezoelectric layer 13. The first additional layer 17 uses an OCA or PSA adhesive material, and the penetration layer 18 is a display screen, a glass layer, or a metal layer.

In this case, similar to Example 1, the piezoelectric layer 13 and the second protective layer 16 form one film layer group. A surface of a side of the piezoelectric layer 13 away from the second protective layer 16 is a strong reflection boundary, and a surface of a side of the second protective layer 16 away from the piezoelectric layer 13 is a strong reflection boundary. The piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15).

The substrate layer 11 and the second protective layer 16 form one film layer group. A surface of a side of the substrate layer 11 away from the piezoelectric layer 13 is a strong reflection boundary, and a surface of a side of the second protective layer 16 away from the piezoelectric layer 13 is a strong reflection boundary. In this case, the substrate layer 11, the second protective layer 16, and a film layer between the substrate layer 11 and the second protective layer 16 form one working part, and a sum of target parameters of film layers in the working part is a positive integer multiple of 0.25 (or 0.25±0.15). It can be learned that the transducer in this example includes two film layer groups, so that the transducer has two working parts corresponding to the two film layer groups.

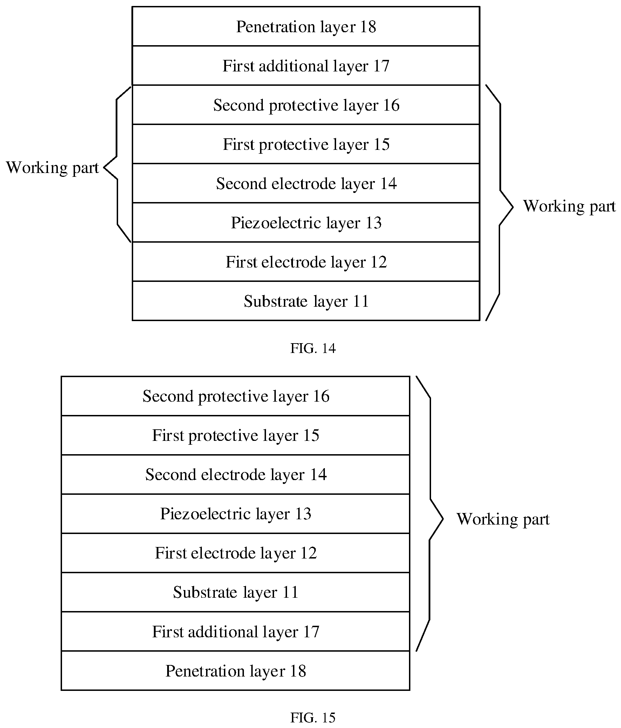

**Example 4:** The first additional layer 17 and the penetration layer 18 in Example 3 may alternatively be located on the side of the second protective layer 16 away from the piezoelectric layer 13. In this case, as shown in FIG. 14, similar to Embodiment 3, the piezoelectric layer 13 and the second protective layer 16 also form one film layer group, and the substrate layer 11 and the second protective layer 16 form one film layer group. The piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15). The substrate layer 11, the second protective layer 16, and a film layer between the substrate layer 11 and the second protective layer 16 form one working part, and a sum of target parameters of film layers in the working part is a positive integer multiple of 0.25 (or 0.25±0.15).

**Example 5:** The substrate layer 11 in Example 3 may alternatively use a flexible material. An acoustic impedance (about 3 MRayl) of the flexible material is close to the acoustic impedance of the piezoelectric layer 13 (a PVDF-TRFE material). Therefore, a strong reflection boundary cannot be formed between the substrate layer 11 and the piezoelectric layer 13. In this case, the piezoelectric layer 13 and the second protective layer 16 cannot form one film layer group.

An acoustic impedance (about 3 MRayl) of the flexible material is close to an acoustic impedance of the first additional layer 17 (an OCA or PSA adhesive material). Therefore, a strong reflection boundary cannot be formed between the substrate layer 11 and the first additional layer 17. In this case, the substrate layer 11 and the second protective layer 16 cannot form one film layer group.

If one strong reflection boundary can be formed between the penetration layer 18 and the first additional layer 17, the first additional layer 17 and the second protective layer 16 may form one film layer group. As shown in FIG. 15, the first additional layer 17, the second protective layer 16, and a part between the first additional layer 17 and the second protective layer 16 form one working part, and a sum of target parameters of film layers in the working part is a positive integer multiple of 0.25.

**Example 6:** Based on Example 1, as shown in FIG. 16, the transducer further includes a second additional layer 19, a third additional layer 20, and a fourth additional layer 21, and a penetration layer 18 is disposed on a side of the fourth additional layer 21 away from the piezoelectric layer 13. Both the second additional layer 19 and the fourth additional layer 21 use an OCA or PSA adhesive material, the third additional layer 20 uses a copper material, and the penetration layer 18 is a display screen, a glass layer, or a metal layer.

In this case, similar to Example 1, the piezoelectric layer 13 and the second protective layer 16 form one film layer group. A surface of a side of the piezoelectric layer 13 away from the second protective layer 16 is a strong reflection boundary, and a surface of a side of the second protective layer 16 away from the piezoelectric layer 13 is a strong reflection boundary. The piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15).

The third additional layer 20 and the second protective layer 16 form one film layer group. A surface of a side of the third additional layer 20 away from the piezoelectric layer 13 is a strong reflection boundary, and a surface of a side of the second protective layer 16 away from the piezoelectric layer 13 is a strong reflection boundary. In this case, the third additional layer 20, the second protective layer 16, and a film layer between the third additional layer 20 and the second protective layer 16 form one working part, and a sum of target parameters of film layers in the working part is a positive integer multiple of 0.25 (or 0.25±0.15). It can be learned that the transducer in this example includes two film layer groups, so that the transducer has two working parts corresponding to the two film layer groups.

In the transducer in Example 6, because the second additional layer and the third additional layer can also be used as working parts, performance of the transducer is better than that of the transducer shown in Example 3.

Example 7: The substrate layer 11 in Example 6 may alternatively use a flexible material. An acoustic impedance (about 3 MRayl) of the flexible material is close to the acoustic impedance of the piezoelectric layer 13 (a PVDF-TRFE material). Therefore, a strong reflection boundary cannot be formed between the substrate layer 11 and the piezoelectric layer 13. In this case, the piezoelectric layer 13 and the second protective layer 16 cannot form one film layer group.

An acoustic impedance (about 3 MRayl) of the flexible material is close to the acoustic impedance of the second additional layer 19 (an OCA or PSA adhesive material). Therefore, a strong reflection boundary cannot be formed between the substrate layer 11 and the second additional layer 19. In this case, the substrate layer 11 and the second protective layer 16 cannot form one film layer group.

In addition, the second additional layer 19 and the second protective layer 16 form one film layer group. A surface of a side of the second additional layer 19 away from the piezoelectric layer 13 is a strong reflection boundary, and a surface of a side of the second additional layer 19 away from the piezoelectric layer 13 is a strong reflection boundary. In this case, as shown in FIG. 17, the second additional layer 19, the second protective layer 16, and a film layer between the second additional layer 19 and the second protective layer 16 form one working part, and a sum of target parameters of film layers in the working part is a positive integer multiple of 0.25 (or 0.25±0.15).

Example 8: Based on the transducer in Example 6, the piezoelectric layer 13 may alternatively use an inorganic piezoelectric material AlN and an alloy material thereof (ScₓAl₁₋ₓN), ZnO and an alloy material thereof (VₓZn₁₋ₓO), or the like; and the piezoelectric layer 13 may alternatively use a piezoelectric ceramic material, such as PZT and an alloy material thereof (PLZT or PNZT), or KNN (KₓNa₁₋ₓNbO₃), or PMN-PT.

Because the material of the piezoelectric layer 13 changes, the first electrode layer, the second electrode layer, and the second protective layer are not first film layers, but the first protective layer is used as a first film layer. The acoustic impedance of the piezoelectric layer 13 changes from low to high (for example, an acoustic impedance of PZT is ~33 MRayl). Therefore, the strong reflection boundary of the transducer in Example 8 changes.

For example, when both the piezoelectric layer and the substrate layer use materials with a high acoustic impedance, the acoustic impedance of the piezoelectric layer 13 is close to the acoustic impedance of the substrate layer 11. Therefore, a strong reflection boundary cannot be formed between the substrate layer 11 and the piezoelectric layer 13. In this case, the piezoelectric layer 13 and the second protective layer 16 cannot form one film layer group.

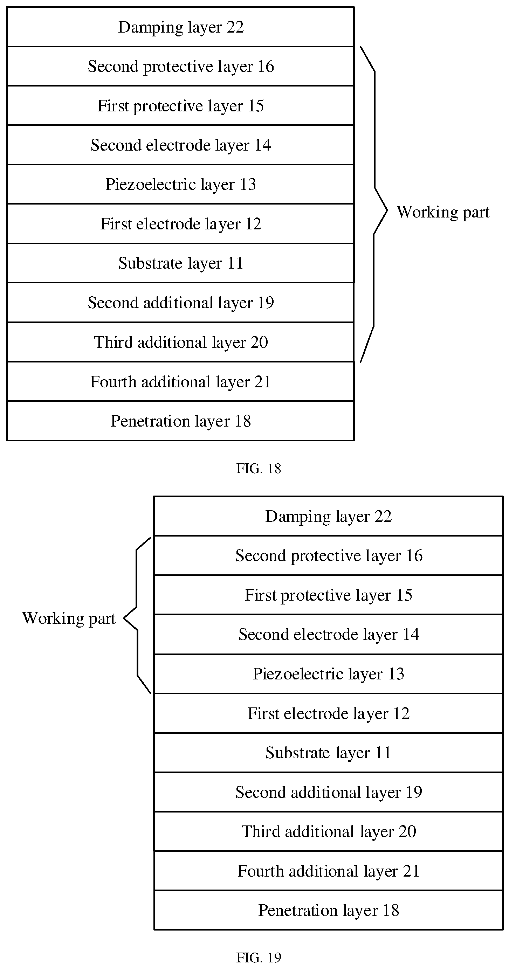

In addition, the third additional layer 20 and the second protective layer 16 form one film layer group. As shown in FIG. 18, the third additional layer 20, the second protective layer 16, and a film layer between the third additional layer 20 and the second protective layer 16 form one working part, and a sum of target parameters of film layers in the working part is a positive integer multiple of 0.25 (or 0.25±0.15).

Example 9: Based on the transducer in Example 8, the substrate layer 11 may alternatively use a flexible material. In this case, a difference between the acoustic impedance of the piezoelectric layer 13 and the acoustic impedance of the substrate layer 11 is large. Therefore, a strong reflection boundary can be formed between the substrate layer 11 and the piezoelectric layer 13, and the piezoelectric layer 13 and the second protective layer 16 form one film layer group. As shown in FIG. 19, the piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15).

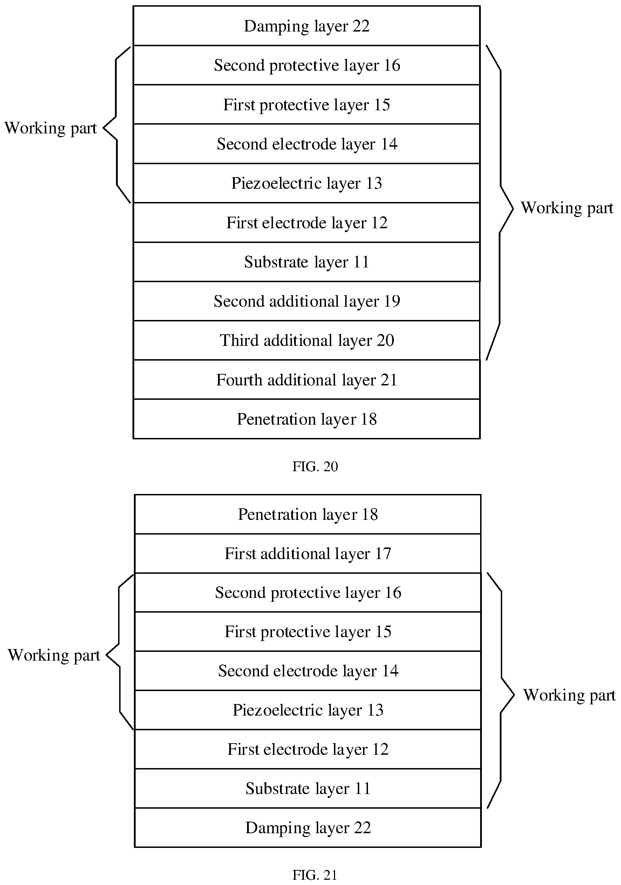

Example **10:** As shown in FIG. 20, based on the transducer in Example 6, the transducer further includes a damping layer 22 located on the side of the second protective layer 16 away from the piezoelectric layer. Acoustic damping of the damping layer 22 (which may be a polymer material, such as a rubber material) is greater than acoustic damping of the second protective layer 16 (a metal material). In addition, addition of the damping layer 22 does not change the film layer group in the transducer. Therefore, in this case, in the transducer in FIG. 18, the piezoelectric layer 13 and the second protective layer 16 form one film layer group, and the third additional layer 20 and the second protective layer 16 form one film layer group.

The piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15). The third additional layer 20, the second protective layer 16, and a film layer between the third additional layer 20 and the second protective layer 16 form one working part, and a sum of target parameters of film layers in the working part is a positive integer multiple of 0.25 (or 0.25±0.15).

**Example 11:** As shown in FIG. 21, based on the transducer in Example 4, the transducer further includes a damping layer 22 located on the side of the substrate layer 11 away from the piezoelectric layer 13. Acoustic damping of the damping layer 22 (which may be a polymer material, such as a rubber material) is greater than acoustic damping of the substrate layer 11. In addition, addition of the damping layer 22 does not change the film layer group in the transducer. Therefore, in this case, in the transducer in FIG. 19, the piezoelectric layer 13 and the second protective layer 16 form one film layer group, and the substrate layer 11 and the second protective layer 16 form one film layer group.

The piezoelectric layer 13, the second protective layer 16, and a film layer between the piezoelectric layer 13 and the second protective layer 16 form one working part, and a sum of target parameters of film layers in the working part is a positive integer multiple of 0.25 (or 0.25±0.15). The substrate layer 11, the second protective layer 16, and a film layer between the substrate layer 11 and the second protective layer 16 form one working part, and a sum of target parameters of film layers in the working part is a positive integer multiple of 0.25 (or 0.25±0.15).

The foregoing 11 examples describe only some transducers provided in this application as examples. It may be understood that the transducer may be alternatively combined arbitrarily based on the features listed in this application. The transducer in each example provided in this application may alternatively have another feature in addition to features of the transducer. For example, both the transducers in Example 8 (as shown in FIG. 18) and Example 9 (as shown in FIG. 19) may further include a damping layer. In addition, features of the transducer in each example provided in this application may alternatively be reduced as required. This is not limited in this application.

This application further provides a transduction apparatus, where the transduction apparatus includes a controller and any transducer provided in the foregoing embodiments; the controller is connected to the transducer, and is configured to provide a first electrical signal for the transducer; and the transducer is configured to emit a first sound wave based on the first electrical signal.

Optionally, the transducer is further configured to receive a second sound wave, and provide a second electrical signal for the controller based on the second sound wave. In this case, the controller is configured to generate an image based on the second electrical signal. It may be understood that the transduction apparatus provided in this application may not need to receive the second sound wave, and the controller may not be configured to generate an image. In this case, the first sound wave may be output as a vibration signal to another circuit for use by the another circuit.

Optionally, the transduction apparatus further includes a penetration layer (such as the penetration layer 18 shown in FIG. 13 and FIG. 15 to FIG. 20), and both the first sound wave and the second sound wave pass through the penetration layer. A position of the penetration layer is not limited in this embodiment of this application. For example, the penetration layer is a film layer located on an outermost side of the transduction apparatus. The penetration layer may be a film layer that can be penetrated by the sound wave, such as a display screen (for example, a bezel-less screen), a glass layer, or a metal layer.

When the first additional layer is adjacent to the penetration layer in the transduction apparatus, the first additional layer may be referred to as a coupling layer, and is configured to couple sound waves on both sides. When the second additional layer, the third additional layer, the fourth additional layer, and the penetration layer in the transduction apparatus are successively adjacent, the second additional layer, the third additional layer, and the fourth additional layer are used as coupling layers, and are configured to couple sound waves on both sides.

Optionally, the controller is further configured to perform fingerprint recognition based on the image. It may be understood that the transduction apparatus provided in this application may not be configured to perform fingerprint recognition based on the image. For example, the controller may control the image to be displayed.

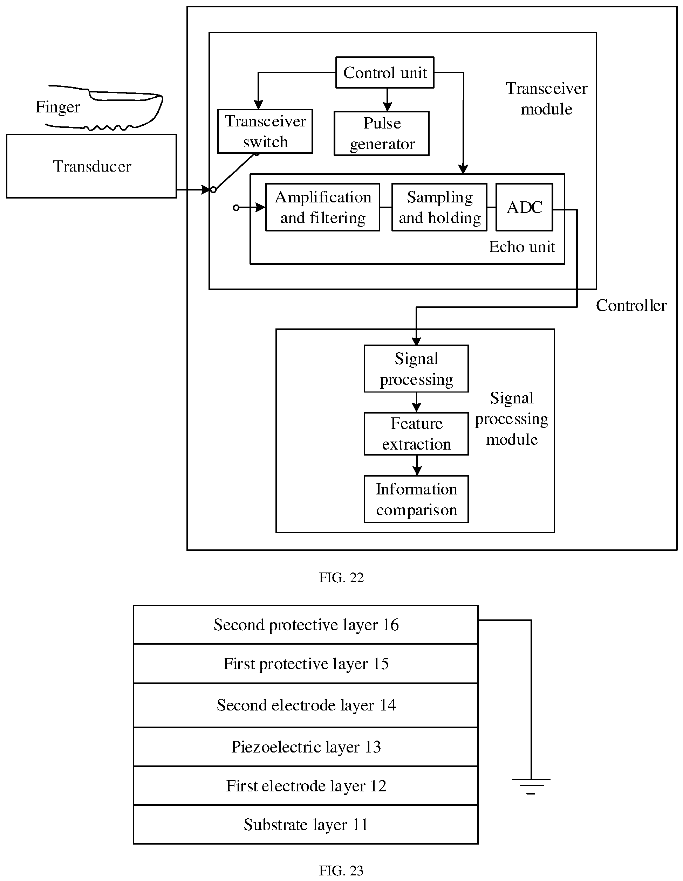

For example, in a fingerprint recognition scenario, as shown in FIG. 22, the controller may include a transceiver module and a signal processing module. The transceiver module includes a control unit, a transceiver switch, a pulse generator, and an echo unit. The control unit connects the transceiver switch, the pulse generator, and the echo unit. The control unit is configured to control the pulse generator to generate a first electrical signal, and control the transceiver switch to connect the pulse generator and the transducer, so that the first electrical signal acts on a working part of the transducer through the transceiver switch to emit a first sound wave; the first sound wave passes through the penetration layer to reach a finger surface, and a valley and a ridge on the finger surface perform echo reflection of different intensity on the first sound wave to form a second sound wave; and after the second sound wave passes through the penetration layer, the working part of the transducer receives the second sound wave and converts the second sound wave into a second electrical signal; and the control unit is configured to control the transceiver switch to connect the echo unit and the transducer, so that the second electrical signal reaches the echo unit through the transceiver switch. The echo unit is configured to convert the second electrical signal into a digital signal, and transmit the digital signal to the signal processing module. The signal processing module is configured to process the digital signal, extract a feature, and then compare the feature with stored fingerprint information to complete fingerprint recognition. The echo unit may sequentially perform amplification and filtering processing, sampling and holding processing, and analog-to-digital conversion processing (for example, perform the analog-to-digital conversion processing by using an analog to digital converter (analog to digital converter, ADC)) on the second electrical signal, to convert the second electrical signal into a digital signal.

In addition, in the transduction apparatus provided in this embodiment of this application, some film layers of the transducer may be grounded, to implement an electromagnetic shielding function, reduce noise of the transduction apparatus, and increase a signal-to-noise ratio.

For example, as shown in FIG. 23, when the second protective layer 16 in the transducer is a conductor (for example, copper), the second protective layer 16 may be grounded.

For another example, when the transducer includes a second additional layer, a third additional layer, and a fourth additional layer, both the second additional layer and the fourth additional layer are insulated (for example, both the second additional layer and the fourth additional layer are adhesive), and the third additional layer is a conductor (for example, the third additional layer is copper), the third additional layer is grounded.

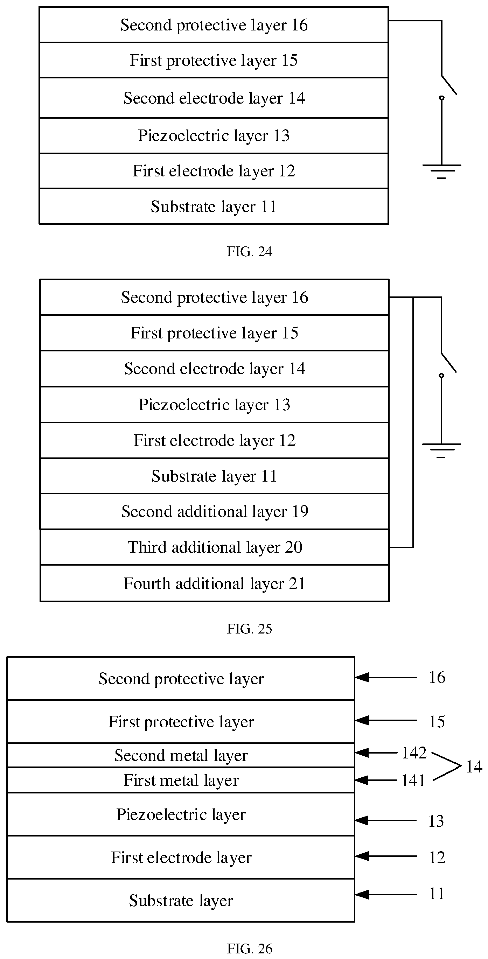

For still another example, as shown in FIG. 24, when the second protective layer 16 in the transducer is a conductor (for example, copper), the transduction apparatus may further include a switch, and the second protective layer 16 may be grounded by using the switch. In this case, the controller is connected to the switch, and the controller is configured to control the switch to be turned off in a phase in which the transducer emits the first sound wave and to be turned on in a phase in which the transducer receives the second sound wave. In this way, in the phase in which the transducer emits the first sound wave, interference caused by the second protective layer to a parasitic capacitance generated when the transducer emits the first sound wave is avoided, a difficulty in controlling the transducer by the controller to emit the first sound wave is reduced, and noise can be shielded by the second protective layer to some extent in a process in which the transducer receives the second sound wave.

For still another example, when the transducer includes a second additional layer, a third additional layer, and a fourth additional layer, both the second additional layer and the fourth additional layer are insulated (for example, both the second additional layer and the fourth additional layer are adhesive), and the third additional layer is a conductor (for example, the third additional layer is copper), the third additional layer is grounded by using the switch. In this case, the controller is connected to the switch, and the controller is configured to control the switch to be turned off in a phase in which the transducer emits the first sound wave and to be turned on in a phase in which the transducer receives the second sound wave. In this way, in the phase in which the transducer emits the first sound wave, interference caused by the third additional layer to a parasitic capacitance generated when the transducer emits the first sound wave is avoided, a difficulty in controlling the transducer by the controller to emit the first sound wave is reduced, and noise can be shielded by the third additional layer to some extent in a process in which the transducer receives the second sound wave.

For still another example, as shown in FIG. 25, when the transducer includes a second additional layer 19, a third additional layer 20, and a fourth additional layer 21, both the second additional layer 19 and the fourth additional layer 21 are insulated (for example, both the second additional layer and the fourth additional layer are adhesive), and both the third additional layer 20 and the second protective layer 16 are conductors (for example, both the third additional layer and the second protective layer are copper), both the third additional layer 20 and the second protective layer 16 are grounded by using the switch. In this case, the controller is connected to the switch, and the controller is still configured to control the switch to be turned off in the phase in which the transducer emits the first sound wave and to be turned on in the phase in which the transducer receives the second sound wave. In this way, in the phase in which the transducer emits the first sound wave, interference caused by the second protective layer to a parasitic capacitance generated when the transducer emits the first sound wave is avoided, a difficulty in controlling the transducer by the controller to emit the first sound wave is reduced, and noise can be shielded to some extent in a process in which the transducer receives the second sound wave. In addition, compared with a shielding effect of the second protective layer 16 in FIG. 24, overall shielding effects of the second protective layer 16 and the third additional layer 20 in FIG. 25 are improved.

It may be understood that the film layers (for example, the second protective layer and the third additional layer) of the transducer may alternatively not be grounded. This is not limited in this embodiment of this application.

An embodiment of this application further provides a terminal. The terminal may be a mobile phone, a tablet computer, or the like. The terminal includes any transduction apparatus provided in embodiments of this application. It may be understood that the terminal may further include another component in addition to the transduction apparatus. For example, the terminal further includes a power supply component, and the power supply component is configured to provide electric energy for an electric component in the transduction apparatus.

In this application, "at least one" refers to one or more, and "a plurality of" refers to two or more. The terms "first", "second", and the like are merely used for a purpose of description, and cannot be understood as an indication or implication of relative importance.

It should be noted that, in the accompanying drawings, for illustration clarity, sizes of some or all layers or sizes of some or all areas may be enlarged. In addition, it may be understood that, when a layer is referred to as being "at" another layer, the layer may be directly on another layer, or there may be an intermediate layer. In addition, it may be understood that, when a layer is referred to as being "below" another layer, the layer may be directly below another layer, or there may be one or more intermediate layers. In addition, it may be further understood that, when a layer is referred to as being "between" two layers, the layer may be a unique layer between the two layers, or there may be one or more intermediate layers. Similar reference signs throughout this specification indicate similar layers. One film layer in this application may be a one-layer structure, or may be obtained by superposing a plurality of layers of structures. Materials of different layers of structures in the plurality of layers of structures may be the same or may be different. One film layer herein may be any film layer in the resonator, for example, the second electrode layer, the first protective layer, or the second protective layer. Each of the at least one film layer in the transducer provided in this application may be obtained by superposing a plurality of layers of structures. This is not limited in this application. For example, the at least one film layer includes the second electrode layer, the first protective layer, and/or the second protective layer.

For example, as shown in FIG. 26, when the second electrode layer 14 is obtained by superposing a plurality of layers of structures, the second electrode layer 14 may be obtained by superposing a first metal layer (for example, a silver paste electrode layer or an electrode layer of another metal material) 141 and a second metal layer (for example, a metal layer with a sub-micrometer thickness) 142, and the second metal layer 142 may be sputtered on a surface of the first metal layer 141 away from the piezoelectric layer 13. Surface roughness of the second metal layer 142 is less than surface roughness of the first metal layer 141, and the second metal layer 142 can improve the surface roughness of the first metal layer 141. A material of the second metal layer 142 may be metal such as gold, copper, chromium, nickel, or aluminum.

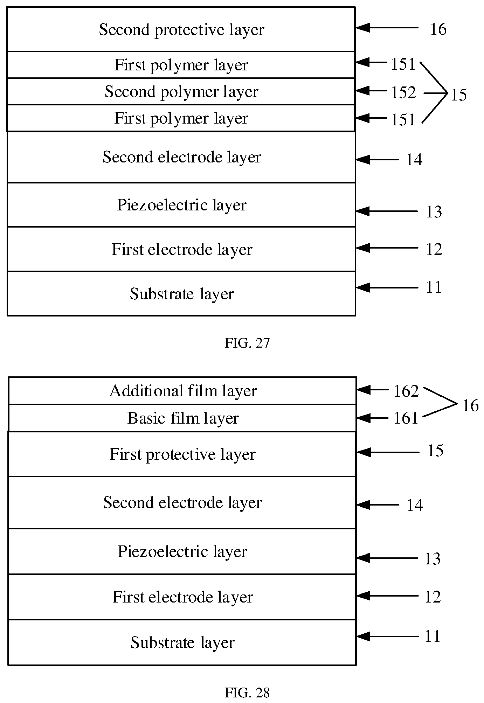

For another example, as shown in FIG. 27, when the first protective layer 15 is obtained by superposing a plurality of layers of structures, the first protective layer 15 includes two first polymer layers 151 and a second polymer layer 152 superposed between the two first polymer layers 151, and hardness of the second polymer layer 152 is greater than hardness of the first polymer layer 151. The second polymer layer 152 may function to electrically isolate the second electrode layer 14 from the second protective layer 16. In addition, when a thickness of the first protective layer 15 is fixed, compared with a first protective layer formed by one first polymer layer 151, a thickness of a first polymer layer 151 in a first protective layer including two first polymer layers 151 and one second polymer layer 152 is reduced, so that a bubble size in the first polymer layer 151 can be reduced. The first polymer layer may be a pressure sensitive adhesive (pressure sensitive adhesive, PSA), an optically clear adhesive (optically clear adhesive, OCA), a hot glue (hot glue), or the like. The rigid polymer layer may be a polyethylene terephthalate (polyethylene terephthalate, PET) layer, polyimide (polyimide, PI), polyethylene (polyethylene, PE), polypropylene (polypropylene, PP), polyvinyl chloride (polyvinyl chloride, PVC), polystyrene (polystyrene, PS), polycarbonate (polycarbonate, PC), or the like. When the first protective layer is of a one-layer structure, the first protective layer may be a PSA, OCA, or hot glue layer.

For still another example, as shown in FIG. 28, when the second protective layer 16 is obtained by superposing a plurality of layers of structures, the second protective layer 16 may be obtained by superposing a base film layer 161 (for example, a copper layer or an aluminum adhesive tape layer, where the aluminum adhesive tape layer includes an aluminum layer and an adhesive layer located on a side of the aluminum layer close to the piezoelectric layer) and an additional film layer 162 deposited on a side of the base film layer 161 away from the piezoelectric layer 13. The additional film layer 162 may be an antioxidant metal layer (for example, metal such as aluminum, gold, or nickel) or a polymer protective layer. The additional film layer 162 can protect the base film layer, to prevent the base film layer from being oxidized.

The term "and/or" in this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In corresponding embodiments provided in this application, it should be understood that the disclosed structures may be implemented in other composition manners. For example, the embodiments described above are merely examples.

The foregoing descriptions are merely optional implementations of this application, but the protection scope of this application is not limited thereto. Any equivalent modification or replacement readily figured out by a person skilled in the art within the technical scope disclosed in this application shall fall within the protection scope of this application. Therefore, the protection scope of this application shall be subject to the protection scope of the claims.

## Claims

1. A transducer, comprising: a substrate layer, a first electrode layer, a piezoelectric layer, a second electrode layer, a first protective layer, and a second protective layer that are sequentially arranged, wherein materials of the first protective layer and the second protective layer are different; and
a sum of target parameters of the piezoelectric layer, the second electrode layer, the first protective layer, and the second protective layer is a positive integer multiple of n, and 0.1≤n≤0.4; and a target parameter of any film layer in the transducer is a ratio of a thickness of the any film layer to a wavelength of a sound wave at an operating frequency of the transducer when the sound wave is transmitted at the any film layer.

2. The transducer according to claim 1, wherein a sum of target parameters of the substrate layer, the first electrode layer, the piezoelectric layer, the second electrode layer, the first protective layer, and the second protective layer is a positive integer multiple of n.

3. The transducer according to claim 1, wherein the transducer further comprises a second additional layer, a third additional layer, and a fourth additional layer;
the fourth additional layer, the third additional layer, the second additional layer, the substrate layer, the first electrode layer, the piezoelectric layer, the second electrode layer, the first protective layer, and the second protective layer are sequentially arranged; and
a sum of target parameters of the third additional layer, the second additional layer, the substrate layer, the first electrode layer, the piezoelectric layer, the second electrode layer, the first protective layer, and the second protective layer is a positive integer multiple of n.

4. The transducer according to claim 3, wherein a material of the second additional layer comprises adhesive, a material of the third additional layer comprises copper, and a material of the fourth additional layer comprises adhesive.

5. The transducer according to any one of claims 1 to 4, wherein an acoustic impedance of the piezoelectric layer is greater than twice an acoustic impedance of the second electrode layer, or an acoustic impedance of the piezoelectric layer is less than one half of an acoustic impedance of the second electrode layer; and the target parameter of the second electrode layer is less than one tenth.

6. The transducer according to any one of claims 1 to 5, wherein the acoustic impedance of the piezoelectric layer is greater than twice an acoustic impedance of the second protective layer, or the acoustic impedance of the piezoelectric layer is less than one half of an acoustic impedance of the second protective layer; and the target parameter of the second protective layer is less than one tenth.

7. The transducer according to any one of claims 1 to 6, wherein a material of the first protective layer comprises adhesive, and a material of the second protective layer comprises metal.

8. The transducer according to any one of claims 1 to 7, wherein the first protective layer is obtained by superposing a plurality of layers of structures.

9. The transducer according to claim 8, wherein the first protective layer comprises two first polymer layers and a second polymer layer superposed between the two first polymer layers, and hardness of the second polymer layer is greater than hardness of the first polymer layer.

10. The transducer according to any one of claims 1 to 9, wherein the transducer meets at least one of the following conditions:
the first electrode layer comprises a plurality of first electrode blocks arranged in an array, the second electrode layer comprises a second electrode block, an orthographic projection of the second electrode block at the substrate layer and an orthographic projection of the piezoelectric layer at the substrate layer have an overlapping region, and orthographic projections of the plurality of first electrode blocks at the substrate layer are located in the overlapping region;
the transducer further comprises a circuit layer located between the substrate layer and the first electrode layer, and the circuit layer is connected to the first electrode layer; and
the transducer further comprises an auxiliary adhesion layer located between the first electrode layer and the piezoelectric layer.

11. The transducer according to any one of claims 1 to 10, wherein a material of the substrate is glass, silicon, or a polymer material.

12. The transducer according to any one of claims 1 to 11, wherein a material of the piezoelectric layer is an organic polymer material or an inorganic piezoelectric material.

13. The transducer according to any one of claims 1 to 12, wherein the operating frequency of the transducer ranges from 5 megahertz to 25 megahertz.

14. The transducer according to any one of claims 1 to 13, wherein the wavelength of the sound wave at the operating frequency of the transducer when the sound wave is transmitted at the any film layer is:
a ratio of a longitudinal wave sound velocity of the sound wave at the operating frequency of the transducer when the sound wave is transmitted at the any film layer to a frequency of the sound wave at the operating frequency of the transducer; or
a ratio of a transverse wave sound velocity of the sound wave at the operating frequency of the transducer when the sound wave is transmitted at the any film layer to a frequency of the sound wave at the operating frequency of the transducer; or
a ratio of a guided-wave sound velocity of the sound wave at the operating frequency of the transducer when the sound wave is transmitted at the any film layer to a frequency of the sound wave at the operating frequency of the transducer.

15. A transduction apparatus, comprising a controller and the transducer according to any one of claims 1 to 14, wherein:
the controller is configured to provide a first electrical signal to the transducer; and
the transducer is configured to emit a first sound wave based on the first electrical signal.

16. The transduction apparatus according to claim 15, wherein the transducer is further configured to receive a second sound wave, and provide a second electrical signal to the controller based on the second sound wave; and
the controller is configured to generate an image based on the second electrical signal.

17. The transduction apparatus according to claim 16, wherein the transduction apparatus comprises a penetration layer; and
both the first sound wave and the second sound wave pass through the penetration layer.

18. The transduction apparatus according to claim 17, wherein the penetration layer is a display screen, a glass layer, or a metal layer.

19. The transduction apparatus according to any one of claims 15 to 18, wherein the controller is further configured to perform fingerprint recognition based on the image.

20. The transduction apparatus according to any one of claims 15 to 19, wherein a second protective layer in the transducer is a conductor, and the second protective layer is grounded.

21. The transduction apparatus according to any one of claims 16 to 19, wherein a second protective layer in the transducer is a conductor, the transduction apparatus further comprises a switch, and the second protective layer is grounded via the switch; and
the controller is configured to control the switch to be turned off in a phase in which the transducer emits the first sound wave and to be turned on in a phase in which the transducer receives the second sound wave.

22. The transduction apparatus according to claim 21, wherein the transducer comprises a second additional layer, a third additional layer, and a fourth additional layer, and the fourth additional layer, the third additional layer, the second additional layer, the substrate layer, the first electrode layer, the piezoelectric layer, the second electrode layer, the first protective layer, and the second protective layer are sequentially arranged; a sum of target parameters of the third additional layer, the second additional layer, the substrate layer, the first electrode layer, the piezoelectric layer, the second electrode layer, the first protective layer, and the second protective layer is a positive integer multiple of n; and
both the second additional layer and the fourth additional layer are insulated, the third additional layer is a conductor, and the third additional layer is grounded via the switch.

23. A terminal, comprising the transduction apparatus according to any one of claims 15 to 22.
